# EUROPEAN PATENT APPLICATION

(11) **EP 1 693 701 A1**
(43) Date of publication of application: **23.08.2006**
(21) Application number: 06003283.6
(22) Date of filing: 17.02.2006
(51) Int. Cl.: G02F 1/1337, C23C 14/46

(54) **Method of forming inorganic orientation film, inorganic orientation film, substrate for electronic devices, liquid crystal panel, and electronic equipment**

(30) Priority: 18.02.2005 JP 2005043004; 18.02.2005 JP 2005043005; 09.11.2005 JP 2005325474
(71) Applicant: SEIKO EPSON CORPORATION, Shinjuku-ku, Tokyo 163-0811 (JP)
(72) Inventor: Ota, Hidenobu, Suwa-shi Nagano 392-8502 (JP)
(74) Representative: HOFFMANN EITLE

(57) **Abstract**

In a method of forming an inorganic orientation film (200), a target (500) is irradiated with ion beams supplied from an ion beam source (S1) to lead out sputter particles from the target (500), and then the sputter particles are made incident on a matrix (100) to form the inorganic orientation film (200), wherein the film formation is carried out without replacing the whole of the target (500) while carrying out a repair processing for supplementing or recovering a defect of the target (500). The target (500) is formed from a plurality of separable members (510,520) so that only a part of the separable members (510,520) can be selected and replaced, and the repair processing is carried out by replacing a member (510) within the plural separable members on which the defect is produced. According to this method, it is possible to manufacture an inorganic orientation film which is excellent in an orientation characteristic and also excellent in light resistance while effectively using the target. This saves resources and gives fewer burdens on an environment. Further, an inorganic orientation film obtained by the forming method, and a substrate for electronic devices provided with the inorganic orientation film are also provided. Furthermore, a liquid crystal panel provided with the in organic orientation film, and electronic equipment provided with the liquid crystal panel are also provided.

## Description

### CROSS-REFERENCE

The entire disclosures of Japanese Patent Applications No. 2005-043004 filed on February 18, 2005, No. 2005-043005 filed on February 18, 2005 and No. 2005-325474 filed on November 9, 2005 are expressly incorporated by reference herein.

### BACKGROUND OF THE INVENTION

### Field of the Invention

The present invention relates to a method of forming an inorganic orientation film, an inorganic orientation film, a substrate for electronic devices, a liquid crystal panel, and electronic equipment, and more particularly relates to a method of forming an inorganic orientation film, an inorganic orientation film formed by the method, a substrate for electronic devices provided with the inorganic orientation film, a liquid crystal panel provided with the inorganic orientation film, and an electronic equipment provided with the liquid crystal panel.

### Description of the Related Art

There is known a projection type display apparatus that projects an image on a screen. In most of such projection type display apparatuss, a liquid crystal panel is used for forming the image.

Such a liquid crystal panel usually has orientation films that are set to develop a predetermined pre-tilt angle to orient liquid crystal molecules in a fixed direction. As a method of manufacturing such orientation films, there is known, for example, a method in which a thin film consisting of a high-molecular compound such as polyimide and formed on a substrate is subjected to rubbing treatment by rubbing the thin film in one direction with a cloth of rayon or the like (see, for example, JP-A No. H10-161133).

However, the orientation films formed of a high-molecular compound such as polyimide may cause photo-deterioration because of various factors such as an environment of use, time of use, and the like. When such photo-deterioration occurs, materials forming the orientation films, liquid crystal layers and the like are likely to decompose, and decomposition products thereof may adversely affect performance of liquid crystal. Further, in the rubbing treatment, static electricity is generated and dust is also produced, thereby lowering reliability of the liquid crystal panel.

For the purpose of solving such a problem, it is attempted to adopt an orientation film formed of an inorganic material. In general, such an inorganic orientation film is formed by an oblique vapor deposition method. When such a method is adopted, a vapor deposition source material scatters in a chamber to be dust, which noticeably deposits on a substrate. The dust also adversely affects a yield of products significantly.

For the purpose of solving the above problem, it is also conceivable to form an inorganic orientation film by means of sputtering. However, in such a case, problems described below occur.

In the sputtering, a disc-like target is used. When a relatively small target is used as the disc-like target, high-energy particles (e.g., ion beams) hit target fixing members of a backing plate as well. As a result, components other than materials forming the target are contained in an orientation film to be formed. If such impurities are contained in a relatively large quantity, characteristics of the orientation film are adversely affected significantly.

In ion beam sputtering for extracting sputter particles by irradiating ion beams on a target, in general, converged ion beams are made incident on the target. Even when such converged ion beams (converged high-energy particle beams) are used, a part of ions (high-energy particles) hit the target fixing member to cause the problem described above. In order to solve such a problem, it is also conceivable to use a sufficiently large target (e.g. with a diameter equal to or larger than 20cm). However, this in turn causes a problem in that it is difficult to efficiently use the target for film formation. In other words, in the ion beam sputtering, although a part of ions diffuses to be made incident on areas other than an aimed area, most of the ions are made incident on a predetermined area (the aimed area) of the target. Thus, the target used for film formation is consumed near the center thereof and most of areas near the periphery thereof cannot be used for film formation. Since a target used for formation of an orientation film is generally expensive, it is not preferable in terms of saving of resources and production cost if the target cannot be effectively used as described above.

When a durable life of a target is short (that is, a quantity usable for film formation is small), a frequency of replacement of the target in a chamber of an apparatus by an operator increases. Every time the target is replaced, vacuum drawing or the like in the chamber has to be performed. This causes further decrease in productivity of the orientation film. Further, the likelihood of invasion of foreign matters into the chamber at the time of replacement of the target also increases. This is not preferable in terms of improvement of a quality of the orientation film to be formed.

### SUMMARY

It is therefore an object of the present invention to provide a method of forming an inorganic orientation film that is capable of manufacturing an inorganic orientation film which is excellent in an orientation characteristic (a function of regulating an orientation state of a liquid crystal material) and also excellent in light resistance while effectively using a target (with a method that saves resources and gives fewer burdens on an environment). Further, it is also an object of the present invention to provide an inorganic orientation film obtained by the forming method, and a substrate for electronic devices provided with the inorganic orientation film. Furthermore, it is also an object of the present invention to provide a liquid crystal panel provided with the inorganic orientation film, and electronic equipment provided with the liquid crystal panel.

In order to achieve the above mentioned objects, the present invention is directed to a method of forming an inorganic orientation film, in which a target is irradiated with ion beams supplied from an ion beam source to lead out sputter particles from the target, and then the sputter particles are made incident on a matrix to form the inorganic orientation film, wherein the film formation is carried out without replacing the whole of the target while carrying out a repair processing for supplementing or recovering a defect of the target.

According to the method of the present invention mentioned above, it is possible to provide a method of forming an inorganic orientation film that is capable of manufacturing an inorganic orientation film which is excellent in an orientation characteristic (a function of regulating an orientation state of a liquid crystal material) and also excellent in light resistance while effectively using a target (with a method that saves resources and gives fewer burdens on an environment).

In the inorganic orientation film forming method according to the present invention, it is preferred that the target is formed from a plurality of separable members so that only a part of the separable members can be selected and replaced, and the repair processing is carried out by replacing a member within the plural separable members on which the defect is produced.

This makes it possible to manufacture an inorganic orientation film which is excellent in an orientation characteristic (a function of regulating an orientation state of a liquid crystal material) and also excellent in light resistance while more effectively using a target (with a method that saves resources and gives fewer burdens on an environment).

Further, in the inorganic orientation film forming method according to the present invention, it is also preferred that the target includes a first member of a column shape and a second member of a cylindrical shape which is arranged so as to surround the outer periphery of the first member.

This makes it possible to sufficiently improve efficiency of use of the target.

In this case, it is preferred that the first member is a column shaped member having a diameter of 25 to 250mm.

This also makes it possible to sufficiently improve efficiency of use of the target.

Further, in the inorganic orientation film forming method according to the present invention, it is also preferred that the diameter of the target as a whole is in the range of 100 to 350mm.

This makes it possible to surely prevent the ion beams from being irradiated on the members other than the target while sufficiently improving efficiency of use of the target. As a result, it is possible to make characteristics of an inorganic orientation film to be formed particularly excellent.

In one embodiment of the inorganic orientation film forming method according to the present invention, it is preferred that the repair processing is carried out by changing the irradiating position of the ion beams on the target with time.

This also makes it possible to manufacture an inorganic orientation film which is excellent in an orientation characteristic (a function of regulating an orientation state of a liquid crystal material) and also excellent in light resistance while more effectively using a target (with a method that saves resources and gives fewer burdens on an environment).

In this embodiment, it is preferred that when the target is irradiated with the ion beams, the target is moved relative to the ion beam source and the matrix.

This also makes it possible to manufacture an inorganic orientation film which is excellent in an orientation characteristic (a function of regulating an orientation state of a liquid crystal material) and also excellent in light resistance while more effectively using a target (with a method that saves resources and gives fewer burdens on an environment).

Further, in this embodiment, it is also preferred that the moving speed of the target relative to the ion source and the matrix is in the range of 0.01 to 40mm/second.

This makes it possible to deposit the sputter particles on a desired portion on the matrix from a desired angle, and as a result, the orientation characteristic of the inorganic orientation film can be made particularly excellent.

Furthermore, in this embodiment, it is also preferred that the relative movement of the target is a reciprocal movement in one-dimensional direction.

This makes it possible to effectively use the target sufficiently while preventing the orientation film forming apparatus from being increased in size and complicated.

Moreover, in this embodiment, it is preferred that the length of the target in the plane from which the ion beams are made incident and in the direction of the movement thereof is longer than the length of the target in its vertical direction.

This also makes it possible to effectively use the target sufficiently while preventing the orientation film forming apparatus from being increased in size and complicated.

Further, in the inorganic orientation film forming method according to the present invention, it is preferred that an acceleration voltage of the ion beams at the irradiating the ion beams is 1200V or more.

This makes it possible to deposit the sputter particles on a desired portion on the matrix from a desired angle, and as a result, the orientation characteristic of the inorganic orientation film can be made particularly excellent. In addition, it is possible to control a shape near the vertexes of the columnar crystals forming the inorganic orientation film to be a shape that makes it possible to stably orient liquid crystal molecules, and as a result, it is also possible to more surely control a pre-tile angle.

Further, in the inorganic orientation film forming method according to the present invention, it is also preferred that an ion beam current of the irradiating ion beams is in the range of 50 to 500mA.

This also makes it possible to deposit the sputter particles on a desired portion on the matrix from a desired angle, and as a result, the orientation characteristic of the inorganic orientation film can be made particularly excellent. In addition, it is possible to control a shape near the vertexes of the columnar crystals forming the inorganic orientation film to be a shape that makes it possible to stably orient liquid crystal molecules, and as a result, it is also possible to more surely control a pre-tile angle.

Furthermore, in the inorganic orientation film forming method according to the present invention, it is also preferred that the sputter particles are made incident on the matrix from the direction inclined at a predetermined angle θs with respect to a vertical direction of a surface of the matrix on which the inorganic orientation film is to be formed, thereby forming the inorganic orientation film in which columnar crystals mainly made from the inorganic material are orientated in an inclined manner with respect to the surface of the matrix on which the inorganic orientation film is to be formed.

With this method, it is possible to more surely control a pre-tilt angle of the inorganic orientation film and make orientation characteristic (a function of regulating an orientation state of a liquid crystal material) of the inorganic orientation film particularly excellent.

In this case, it is preferred that the predetermined angle θs is 40° or larger.

This makes it possible to control a shape near the vertexes of the columnar crystals forming the inorganic orientation film to be a shape that makes it possible to stably orient liquid crystal molecules, and as a result, the orientation characteristic of the inorganic orientation film can be made more excellent.

Moreover, in the inorganic orientation film forming method according to the present invention, it is also preferred that the shaped of the columnar crystals near the vertexes thereof are controlled by controlling energy and/or the number of the sputter particles that reach the matrix.

This also makes it possible to control a shape near the vertexes of the columnar crystals forming the inorganic orientation film to be a shape that makes it possible to stably orient liquid crystal molecules, and as a result, the orientation characteristic of the inorganic orientation film can be made more excellent.

Moreover, in the inorganic orientation film forming method according to the present invention, it is also preferred that the columnar crystals are oriented with being inclined at a predetermined angle θc with respect to the matrix.

This makes it possible to provide a proper pre-tilt angle, thereby enabling to regulate the orientation of the liquid crystal molecules more appropriately.

Moreover, in the inorganic orientation film forming method according to the present invention, it is also preferred that the inorganic orientation film is formed of an inorganic material including silicon oxide.

This also makes it possible to deposit the sputter particles on a desired portion on the matrix from a desired angle, and as a result, the orientation characteristic of the inorganic orientation film can be made particularly excellent. In addition, it is possible to control a shape near the vertexes of the columnar crystals forming the inorganic orientation film to be a shape that makes it possible to stably orient liquid crystal molecules, and as a result, it is also possible to more surely control a pre-tile angle.

Another aspect of the present invention is directed to an inorganic orientation film formed by the inorganic orientation film forming method as defined above.

Such an inorganic orientation film is excellent in an orientation characteristic (a function of regulating an orientation state of a liquid crystal material) and also excellent in light resistance.

In such an inorganic orientation film, it is preferred that an average thickness of the inorganic orientation film is in the range of 0.02 to 0.3µm.

This makes it possible to provide a proper pre-tilt angle, thereby enabling to regulate the orientation of the liquid crystal molecules more appropriately.

Other aspect of the present invention is directed to a substrate for electronic devices, comprising a substrate on which electrodes and inorganic orientation films described above are provided.

Such a substrate for electronic devices can also have excellent orientation characteristic (a function of regulating an orientation state of a liquid crystal material) and excellent light resistance.

Still other aspect of the present invention is directed to a liquid crystal panel comprising an inorganic orientation films as described above and a liquid crystal layer.

Such a liquid crystal panel can also have excellent orientation characteristic (a function of regulating an orientation state of a liquid crystal material) and excellent light resistance.

Yet other aspect of the present invention is directed to electronic equipment provided with the liquid crystal panel as described above.

Such electronic equipment can provide high reliability.

These and other objects, structures and advantages of the present invention will be more apparent from the following detailed description of the invention and the examples thereof which proceeds with reference to the accompanying drawings.

### BRIEF DESCRIPTION OF THE DRAWINGS

Fig. 1 is a schematic longitudinal sectional view showing the liquid crystal panel of the first embodiment of the present invention.
Fig. 2 is a longitudinal sectional view showing an inorganic orientation film formed by the method of the present invention.
Fig. 3 is a schematic diagram of the orientation film forming apparatus used for the method of forming an inorganic orientation film in the first embodiment of the present invention.
Fig. 4 is a perspective view for showing a shape of a target used in the first embodiment.
Fig. 5 is also a perspective views for showing a shape of another target used in the first embodiment.
Fig. 6 is a schematic diagram of an orientation film forming apparatus used for the method of forming an inorganic orientation film of the second embodiment of the present invention.
Fig. 7 is a diagram for showing a shape of a target used in the second embodiment and a moving direction of the target.
Fig. 8 is a schematic longitudinal sectional view showing the liquid crystal panel of the second embodiment of the present invention.
Fig. 9 is a perspective view of a personal computer of a mobile type (or a notebook type) to which the electronic equipment of the present invention is applied.
Fig. 10 is a perspective view of a cellular phone (including a Personal Handy-Phone System (PHS)) to which the electronic equipment of the present invention is applied.
Fig. 11 is a perspective view of a digital still camera to which the electronic equipment of the present invention is applied.
Fig. 12 is a diagram schematically showing an optical system of electronic equipment (a projection type display apparatus) of the present invention.
Fig. 13 is a perspective view which shows a shape of a target.
Fig. 14 is a perspective view which show a shape of other target

### DETAILED DESCRIPTION OF THE INVENTION

Hereinbelow, embodiments of the present invention will be described in detail with reference to the accompanying drawings.

Prior to explanation of a method of forming an inorganic orientation film, a liquid crystal panel of a first embodiment of the present invention which includes an orientation film of the present invention will be explained.

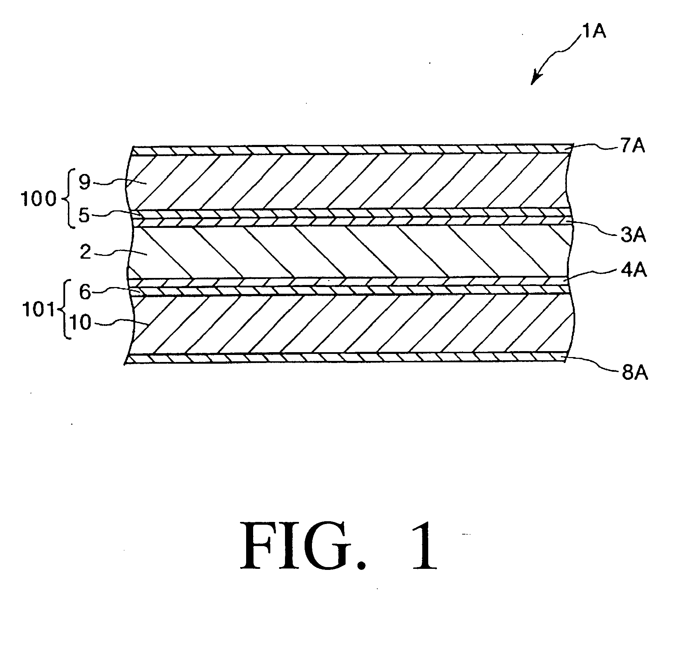

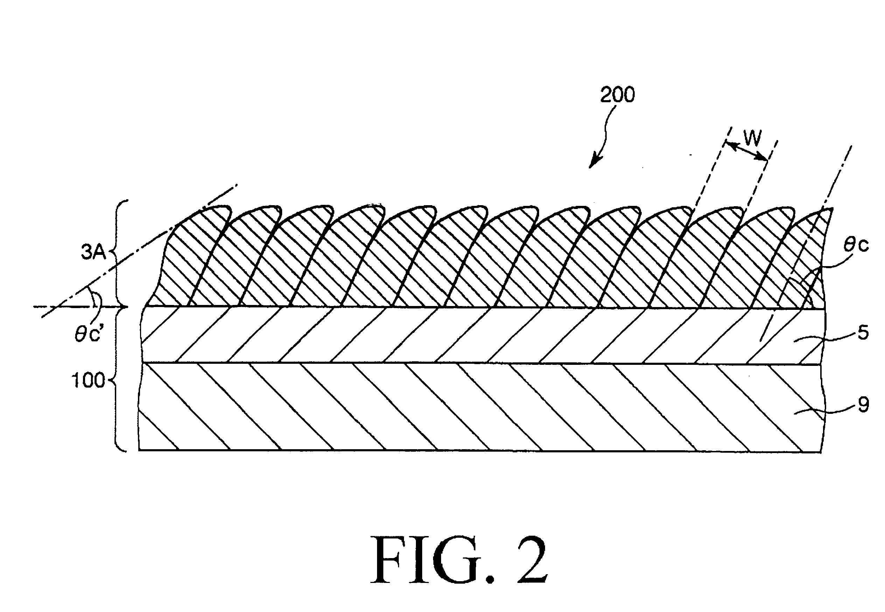

Fig. 1 is a schematic longitudinal sectional view showing the liquid crystal panel of the first embodiment of the present invention. Fig. 2 is a longitudinal sectional view showing an inorganic orientation film formed by the method of the present invention.

As shown in Fig. 1, a liquid crystal panel 1A includes a liquid crystal layer 2, inorganic orientation films 3A and 4A, transparent conductive films 5 and 6, polarizing films 7A and 8A, and substrates 9 and 10.

The liquid crystal layer 2 is mainly formed of a liquid crystal material.

The liquid crystal material forming the liquid crystal layer 2 may be any liquid crystal material such as nematic liquid crystal or smectic liquid crystal as long as the liquid crystal material can be oriented. However, in the case of a TN-type liquid crystal panel, a liquid crystal material forming the nematic liquid crystal is preferable. Examples of the liquid crystal material include phenylcyclohexane derivative liquid crystal, biphenyl derivative liquid crystal, vinylcyclohexane derivative liquid crystal, terphenyl derivative liquid crystal, phenylether derivative liquid crystal, phenylester derivative liquid crystal, bicyclohexane derivative liquid crystal, azometin derivative liquid crystal, azoxy derivative liquid crystal, pyrimidine derivative liquid crystal, dioxane derivative liquid crystal, and cubane derivative liquid crystal, and the like. The liquid crystal material also include liquid crystal molecules obtained by introducing a fluorine substituent group such as monofluoro group, diofluoro group, trifluoro group, trifluoromethyl group, or trifluoromethoxy group to the nematic liquid crystal molecules.

The inorganic orientation films 3A and 4A are arranged on both surfaces of the liquid crystal layer 2.

The inorganic orientation film 3A is formed on a matrix 100 consisting of the transparent conductive film 5 and the substrate 9 described later. The inorganic orientation film 4A is formed on a matrix 101 consisting of the transparent conductive film 6 and the substrate 10 described later.

The inorganic orientation films 3A and 4A have a function of regulating an orientation state (at the time when no voltage is applied) of the liquid crystal material (liquid crystal molecules) forming the liquid crystal layer 2.

These inorganic orientation films 3A and 4A are formed by, for example, a method described later (that is, a method of forming an inorganic orientation film of the present invention). As shown in Fig. 2, in the inorganic orientation film 3A (4A), columnar crystals are arranged in a state in which each of the columnar crystals is tilted by a predetermined angle θc in a predetermined (fixed) direction with respect to a surface of the matrix 10 (that is, the surface of the transparent conductive film 5) on which the inorganic orientation film 3A is to be formed. In particular, in this embodiment, a shape near each of vertexes of the columnar crystals forming the inorganic orientation films 3A and 4A is formed into a shape that makes it possible to stably orient the liquid crystal material.

In more details, in this embodiment shown in Fig. 2, each of the columnar crystals forming the inorganic orientation film 3A (4A) has, at the vicinity of the vertex thereof, a relatively flat portion having an inclined surface. The relatively flat portion is inclined so as to define an angle θc' between the inclined surface thereof and the surface of the matrix 100 on which the inorganic orientation film is formed, wherein the angle θc' is smaller than the tilt angle θc of the columnar crystal. With such a structure, the liquid crystal molecules are arranged in a stable state in the relatively flat portions of the respective columnar crystals. Thus, it is possible to provide a proper pre-tilt angle, thereby enabling to regulate rising of the liquid crystal molecules at the time of application of a voltage more appropriately.

The tilt angle θc of each of the columnar crystals with respect to the surface of the matrix 100 is preferably 30 to 60° and more preferably 40 to 50°. This makes it possible to provide a more proper pre-tilt angle, thereby enabling to regulate an orientation state of the liquid crystal molecules more appropriately.

A width W of such columnar crystal is preferably 10 to 40nm and more preferably 10 to 20nm. This also makes it possible to provide a more proper pre-tilt angle, thereby enabling to regulate an orientation state of the liquid crystal molecules more appropriately.

Each of the inorganic orientation films 3A and 4A is mainly formed of an inorganic material. In general, the inorganic material has excellent chemical stability as compared to an organic material. Thus, the inorganic orientation films 3A and 4A have particularly excellent light resistance as compared to an orientation film formed of the organic material as in the past.

Further, it is preferred that the inorganic material forming the inorganic orientation films 3A and 4A can be crystallized in a columnar shape as shown in Fig. 2. This makes it possible to more easily regulate an orientation state, that is a pre-tilt angle, of the liquid crystal molecules forming the liquid crystal layer 2 at the time when no voltage is applied.

As the inorganic material described above, it is possible to use various metal oxides. Examples of the metal oxide include silicon oxide such as SiO₂ or SiO, aluminum oxide such as Al₂O₃, zinc oxide such as ZnO, MgO, and ITO, and the like. Among these metal oxides, it is particularly preferable to use silicon oxide. Consequently, a liquid crystal panel obtained has more excellent light resistance.

Preferably, each of the inorganic orientation films 3A and 4A has an average thickness of 0.02 to 0.3µm, and more preferably has an average thickness of 0.02 to 0.08µm. When the average thickness is less than the lower limit value, it may be difficult to sufficiently uniformalize pre-tilt angles in respective portions. On the other hand, when the average thickness exceeds the upper limit value, it is likely that a driving voltage increases and thereby power consumption also increases.

The transparent conductive film 5 is arranged on an outer surface of the inorganic orientation film 3A, that is on a surface of the inorganic orientation film 3A opposite to the surface thereof which faces the liquid crystal layer 2. Similarly, the transparent conductive film 6 is arranged on an outer surface of the inorganic orientation film 4A, that is on a surface of the inorganic orientation film 4A opposite to the surface thereof which faces the liquid crystal layer 2.

The transparent conductive films 5 and 6 have a function of driving (changing an orientation of) the liquid crystal molecules of the liquid crystal layer 2 when an electrical current flows therebetween.

Control for the electrical current flowing between the transparent conductive films 5 and 6 is performed by controlling an electric current supplied from a control circuit (not shown in the figure) connected to the transparent conductive films.

The transparent conductive films 5 and 6 have electrical conductivity and are formed of, for example, indium tin oxide (ITO), indium oxide (IO), or tin oxide (SnO₂).

The substrate 9 is arranged on an outer surface of the transparent conductive film 5, that is, on a surface of the transparent conductive film 5 opposite to the surface thereof which faces the inorganic orientation film 3A. Similarly, the substrate 10 is arranged on an outer surface of the transparent conductive film 6, that is, on a surface of the transparent conductive film 6 opposite to the surface thereof which faces the inorganic orientation film 4A.

The substrates 9 and 10 have a function of supporting the liquid crystal layer 2, the inorganic orientation films 3A and 4A, and the transparent conductive films 5 and 6 described above as well as the polarizing films 7A and 8A described later. A material forming the substrates 9 and 10 is not specifically limited. Examples of the material include glass such as quartz glass and a plastic material such as polyethylene terephthalate. Among these materials, in particular, a material formed of glass such as quartz glass is preferable. This makes it possible to obtain a liquid crystal panel that is less likely to be warped or bent and has excellent stability. In this regard, it is to be noted that seal material, wiring, and the like are omitted from Fig. 1.

The polarizing film (a sheet polarizer or a polarization film) 7A is arranged on an outer surface of the substrate 9, that is on a surface of the substrate 9 opposite to the surface thereof which faces the transparent conductive film 5. Similarly, the polarizing film (a sheet polarizer or a polarization film) 8A is arranged on an outer surface of the substrate 10, that is on a surface of the substrate 10 opposite to the surface thereof which faces the transparent conductive film 6.

Examples of a constituent material forming the polarizing films 7A and 8A include polyvinyl alcohol (PVA) and the like. These polarizing films may be formed of a material obtained by doping iodine in the constituent material mentioned above.

Further, as the polarizing films 7A and 8A, it is possible to use films obtained by extending the films formed of the abovementioned material in uniaxial direction.

By using such polarizing films 7A and 8A, it is possible to more surely perform control for light transmittance by adjusting an amount of electrical current flowing between the transparent conductive films 5 and 6.

A direction of the polarizing axis of each of the polarizing films 7A and 8A is usually determined according to an orientation direction of each of the inorganic orientation films 3A and 4A.

In this embodiment, the inorganic orientation films 3A and 4A having the structure shown in Fig. 2 are explained. However, the inorganic orientation films of the present invention are not limited thereto. The inorganic orientation films may be formed in any shape as long as the liquid crystal molecules are stably oriented in the shape.

Next, a method of forming an inorganic orientation film of the present invention and an orientation film forming apparatus used for formation of an inorganic orientation film of the present invention will be explained.

First, the method of forming an orientation film in the first embodiment of the present invention will be explained.

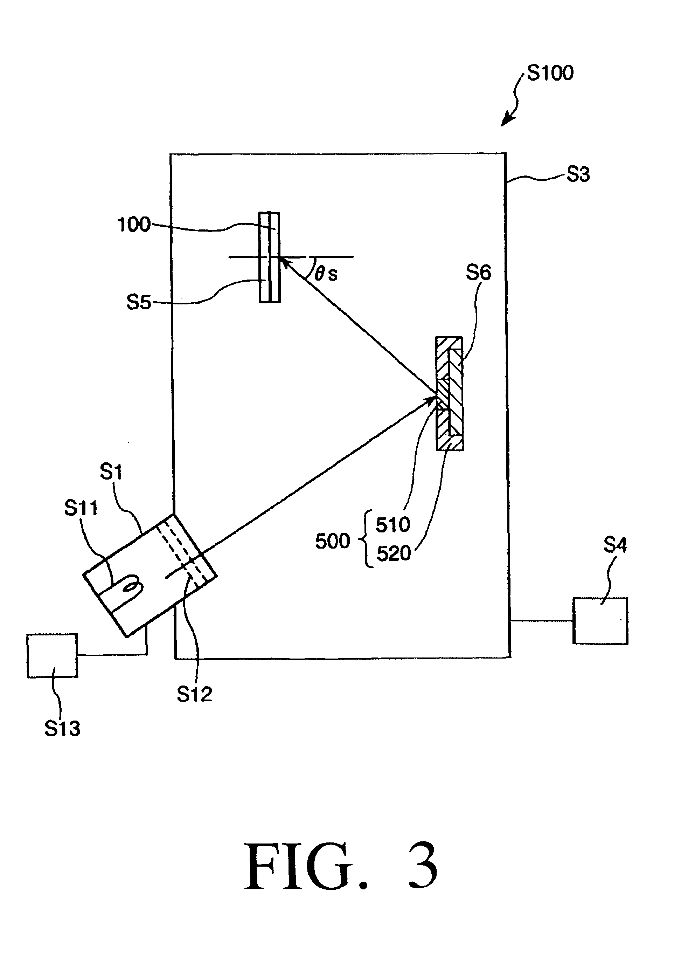

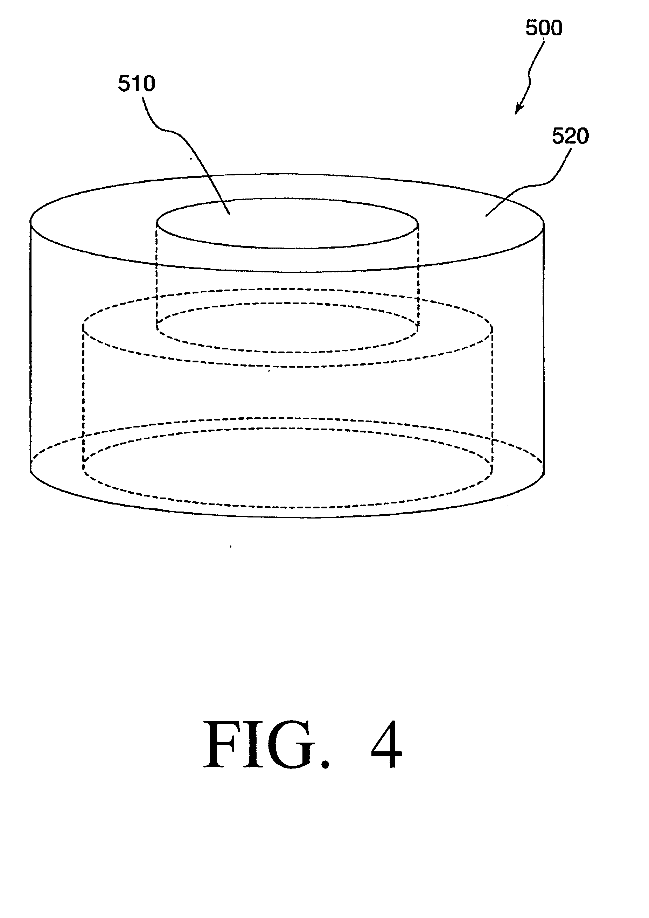

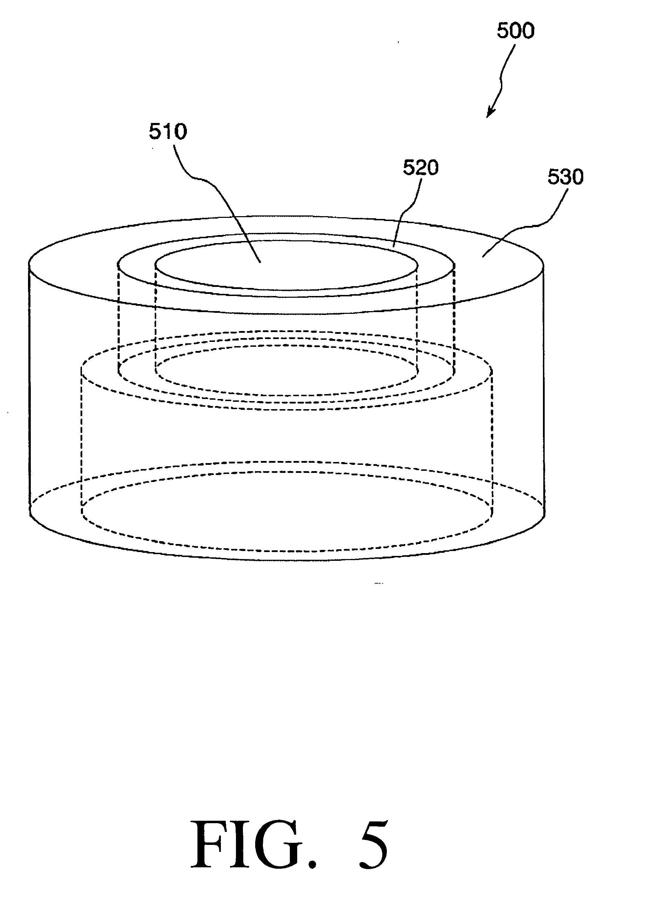

Fig. 3 is a schematic diagram of the orientation film forming apparatus used for the method of forming an inorganic orientation film of the first embodiment of the present invention. Fig. 4 is a perspective view for showing a shape of a target used in this embodiment, and Fig. 5 is also a perspective views for showing a shape of another target used in this embodiment.

First, the orientation film forming apparatus used in this embodiment will be explained.

An orientation film forming apparatus S100 shown in Fig. 3 includes an ion source (an ion beam source) S1 that irradiates ion beams, a vacuum chamber S3, an exhaust pump S4 that controls a pressure in the vacuum chamber S3, a matrix holder S5 that fixes a matrix, on which an inorganic orientation film is to be formed, in the vacuum chamber S3, and a target holding member (a backing plate) S6 that holds a target 500.

The ion source S1 includes a filament S11 and lead-out electrodes S12. A gas supply source S13 that supplies gas into the ion source S1 is connected to the ion source S1.

The target holding member S6 is usually formed of a metal material excellent in thermal conductivity such as stainless steel, copper, copper alloy, or the like. When an inorganic orientation film is formed, the target 500 is fixed to the target holding member S6 via a bonding agent of In or the like.

The method of forming an inorganic orientation film of the first embodiment of the present invention using the orientation film forming apparatus having the structure shown in the figure will be explained. Hereinbelow, a description will be made with regard to a representative case where the inorganic orientation film 3A is to be formed.
<1> First, the target 500 is set in the target holding member S6 in the vacuum chamber S3. A material forming the target 500 is appropriately selected according to a material forming the inorganic orientation film 3A. For example, in the case where an inorganic orientation film is formed of SiO₂, it is preferred that the target 500 is also formed of SiO₂. Further, in the case where an inorganic orientation film is formed of SiO, it is preferred that the target 500 is also formed of SiO. As shown in Fig. 4, the target 500 includes a first member 510 of a columnar shape (a disc shape) and a second member 520 of a cylindrical shape. These members (the first member 510 and the second member 520) are in close contact with each other on an outer peripheral surface of the first member 510 (a peripheral surface of a column) and an inner peripheral surface of the second member 520. However, it is possible to separate the members as required. The target 500 will be explained in detail later.
<2> Next, the matrix 100 is set on the matrix holder S5 in the vacuum chamber S3.
<3> Next, the vacuum chamber S3 is decompressed by the exhaust pump S4.
<4> Next, gas is supplied into the ion source S1 from the gas supply source S13.
<5> Next, a voltage is applied to the filament S11 from a power supply (not shown in the figure) to generate thermal electrons.

The thermal electrons generated in this way collide with the gas led into the ion source S1. Consequently, the gas ionizes to generate plasma. In such a state, an ion acceleration voltage is applied to the lead-out electrodes S12 to accelerate ions and irradiate the target with the ions in the form of ion beams.

Sputter particles are led out from the target 500 which are irradiated with the ion beams. The sputter particles are made incident on the matrix 100 so as to be deposited thereon.

By continuing the irradiation of the ion beams, the deposition of the sputter particles on the matrix 100 progress. As a result, a substrate (a substrate for electronic devices of the present invention, that is a substrate 200 for electronic devices) in which the inorganic orientation film 3A is formed on the matrix 100 is obtained.

Thickness of the target 500 is reduced with the elapse of time by the irradiation of the ion beams on the target 500 as described above. Thus, when film formation is repeated, it is necessary to replace the target.

Usually, in the ion beam sputtering, ion beams are irradiated on an area near the center of a target (near the center of a circle) in order to prevent ion beams from being irradiated on a member other than the target. Therefore, in the conventional method, the area near the center of the target is mainly consumed while an area near an outer periphery of the target is rarely consumed and remains as it is. In other words, the target cannot be effectively used and a large area that cannot be used for film formation remains as it is. This is not preferable in terms of saving of resources, production cost, and the like. When a relatively small target is used for the purpose of avoiding these problems, the ion beams also hit a holding member for holding the target so that components other than the constituent material of the target are contained in an orientation film to be formed.

On the other hand, in the present invention, an orientation film is formed while performing repair processing for supplementing or recovering a defect of a target without replacing the entire target. This makes it possible to improve efficiency of use of the target while sufficiently preventing occurrence of inconveniences caused by ion beams hitting members other than the target.

In particular, in the structure shown in the figure according to this embodiment, the target 500 including the first member 510 and the second member 520, which are separable as required, is used. In other words, the target 500 is formed from separable plural members, so that a part of the members can be replaced with a corresponding new member. The repair processing is performed by appropriately replacing a member in which a defect has been produced by the ion breams among the members with a corresponding new member. This makes it possible to improve efficiency of use of the target 500 while sufficiently avoiding occurrence of inconveniences caused by the ion beams hitting members other than the target 500.

In other words, ion particles forming the ion beams collide with the first member 510 forming the area near the center of the target 500 at extremely high possibility. Thus, consumption of the target 500 partially progresses mainly in the first member 510. On the other hand, the ion beams (the ion particles forming the ion beams) are effectively prevented from being irradiated on the members other than the target 500 by the second member 520 arranged to surround the outer periphery of the first member 510. Therefore, when formation of orientation films (film formation) is repeated, it is possible to replace only the first member 510 in which consumption due to the film formation progresses, and continue to use the second member 520. As a result, it is possible to improve efficiency of use of the target 500 as a whole.

A diameter of the first member 510 is preferably in the range of 25 to 250mm, more preferably in the range of 50 to 100mm, and still more preferably in the range of 55 to 75mm. This makes it possible to set selectability of irradiation of the ion beams on the first member 510 extremely high. As a result, it is possible to further improve efficiency of use of the target 500. If the diameter of the first member 510 is less than the lower limit value, the possibility of collision of the ion particles forming the ion beams with the second member 520 increases. As a result, frequency of replacement of the second member 520 (a ratio of frequency of replacement of the second member 520 with respect to frequency of replacement of the first member 510) also increases. This means that there is a tendency that efficiency of use of the target 500 as a whole decreases. On the other hand, when the diameter of the first member 510 exceeds the upper limit value, a percentage of areas that cannot be used for film formation in the first member 510 increases. As a result, it is likely that efficiency of use of the target 500 as a whole decreases.

A diameter of the target 500 as a whole (an external diameter of the second member 520) is preferably in the range of 100 to 350mm, more preferably in the range of 110 to 310mm, and still more preferably in the range of 120 to 300mm. This makes it possible to surely prevent the ion beams from being irradiated on the members other than the target 500 while sufficiently improving efficiency of use of the target 500. As a result, it is possible to make characteristics of an inorganic orientation film to be formed particularly excellent. When the diameter of the target 500 as a whole is less than the lower limit value, it is likely that it is difficult to sufficiently prevent the ion beams from being irradiated on the members other than the target 500. On the other hand, when the diameter of the target 500 as a whole exceeds the upper limit value, a percentage of areas not used for film formation in the target 500 increases. As a result, it is likely that efficiency of use of the target 500 as a whole decreases.

In the above explanation, the target 500 includes the first member 510 and the second member 520. However, the target 500 may include three or more members (a fist member, a second member, a third member, and the like). For example, as shown in Fig. 5, three members may be concentrically arranged in the target 500 (from the center side, the first member 510, the second member 520, and a third member 530). This makes it possible to further improve efficiency of use of the target 500 as a whole. In other words, for example, it is possible to set possibility of collision of ion particles forming ion beams to be smaller in an order of the first member 510, the second member 520, and the third member 530. When it is necessary to replace the second member 520, for example, it is possible to use the third member 530 without replacing the same. In the case where the target 500 includes three or more members, diameters (external diameters) of the respective members may be smaller than the diameters described above.

When ion beams are irradiated, it is preferable to set a setting angle of the matrix holder S5 so as to make sputter particles generated from the target 500 incident on the matrix 100 from a direction tilted by a predetermined angle (an irradiation angle) θs with respect to the vertical direction of the surface forming the inorganic orientation film 3A. This makes it possible to form an inorganic orientation film in which colunmar crystals mainly formed of an inorganic material are oriented in a tilted state with respect to the surface of the matrix on which the inorganic orientation film it to be formed. As a result, it is possible to more surely control a pre-tilt angle of the inorganic orientation film and make orientation characteristic (a function of regulating an orientation state of a liquid crystal material) of the inorganic orientation film particularly excellent.

The angle θs is preferably equal to or larger than 40°, more preferably equal to or larger than 45°, still more preferably 50 to 87°, and even more preferably 70 to 87°. This makes it possible to form a shape near the vertexes of the columnar crystals forming the inorganic orientation film 3A as a shape that makes it possible to more stably orient liquid crystal molecules. As a result, the inorganic orientation film 3A to be obtained has a more excellent function of regulating an orientation state of liquid crystal molecules. When the angle θs is too small, a sufficient pre-tilt angle is not obtained, and thus there is a possibility that the function of regulating an orientation state of liquid crystal molecules is not sufficiently exhibited. On the other hand, when the angle θs is too large, it is difficult to surely deposit sputter particles led out from the target 500 on the matrix 100. As a result it is likely that adhesiveness between the matrix 100 and the inorganic orientation film 3A is deteriorated.

The inventor has found that it is possible to suitably control an orientation characteristic of an inorganic orientation film by controlling energy and/or the number of sputter particles that reach a matrix when film formation is performed as described above. More specifically, by controlling energy and/or the number of sputter particles that reach the matrix, it is possible to form a shape near the vertexes of the columnar crystals forming the inorganic orientation film 3A as a shape that makes it possible to more stably orient liquid crystal molecules. As a result, it is possible to further improve the orientation characteristic of the inorganic orientation film.

Moreover, it is preferable that at least one of conditions (1) and (2) below is satisfied, and it is more preferable that the two conditions are simultaneously satisfied.
(1) An acceleration voltage of ion beams applied to the lead-out electrodes S12 is equal to or higher than 1200V.
(2) An ion beam current of ion beams irradiated is 50 to 500mA.

By satisfying at least one of the conditions (1) and (2), it is possible to form a shape near the vertexes of the columnar crystals forming the inorganic orientation film as a shape that makes it possible to more stably orient liquid crystal molecules. As a result, it is possible to more surely control a pre-tilt angle.

In particular, the effects described above become more conspicuous when the conditions (1) and (2) are simultaneously satisfied.

As described above, an acceleration voltage of ion beams is preferably equal to or higher than 1200V. More preferably, the acceleration voltage is equal to or higher than 1400V. When the acceleration voltage is lower than the lower limit value, it may be difficult to surely control a shape near the vertexes of the columnar crystals.

As described above, an ion beam current is preferably 50 to 500mA. More preferably, the ion beam current is 200 to 500mA. This makes it possible to more surely control a shape near the vertexes of the columnar crystals, irradiate the ion beams on an aimed portion (improve selectability of an irradiation position by the ion beams), and further improve efficiency of use of a target. When the ion beam current is less than the lower limit value, a sputter rate decreases and sufficient productivity is not obtained in some cases. On the other hand, when the ion beam current exceeds the upper limit value, fluctuation tends to occur in an orientation characteristic of liquid crystal molecules.

In general, when sputter particles are made incident on a matrix in a tilted state under predetermined conditions, it is possible to grow columnar crystals tilted in a direction corresponding to an incidence angle (an irradiation angle) of the sputter particles, thereby enabling an inorganic orientation film as a whole to have an orientation characteristic. On the other hand, however, there is a case that fluctuation occurs in an orientation characteristic of liquid crystal molecules. In this embodiment, when the conditions described above are satisfied, it is possible to control a shape near the vertexes of the columnar crystals forming the inorganic orientation film 3A to be a shape that makes it possible to stably orient liquid crystal molecules. As a result, it is possible to more surely control a pre-tile angle.

A pressure in the vacuum chamber S3, that is, a pressure of the atmosphere in forming the inorganic orientation film 3A is preferably equal to or lower than 5.0×10⁻²Pa and more preferably equal to or lower than 1.0×10⁻²Pa. This makes it possible to form the inorganic orientation film 3A in which liquid crystal molecules can be more stably orientated. On the other hand, when the pressure in the vacuum chamber S3 is too high, linearity of sputter particles may be deteriorated. As a result, it is likely that columnar crystals are not sufficiently formed. Further, it is also likely that orientations of crystals are not sufficiently aligned.

Gas supplied into the ion source S1 from the gas supply source S13 is not specifically limited. However, the gas is preferably a rare gas and more preferably an argon gas. This makes it possible to improve a formation speed (a sputter rate) of the inorganic orientation film 3A.

Temperature of the matrix 100 in forming the inorganic orientation film 3A is preferably relatively low. Specifically, the temperature of the matrix 100 is preferably set to be equal to or lower than 150°C, more preferably set to be equal to or lower than 80°C, and still more preferably set to be 20 to 50°C. This makes it possible to control a phenomenon in which sputter particles adhering to the matrix 100 move from a position where the sputter particles adhere to the matrix 100 first, that is, a phenomenon called migration, thereby enabling to form the inorganic orientation film 3A in which liquid crystal molecules can be more stably oriented. The matrix 100 may be cooled as required such that temperature of the matrix 100 in forming the inorganic orientation film 3A is within the range described above.

A formation speed (a film formation speed) of the inorganic orientation film 3A is not specifically limited. However, the formation speed is preferably 1 to 15nm/minute and more preferably 6 to 10nm/minute. This makes it possible to more efficiently form an inorganic orientation film without spoiling an orientation characteristic of the inorganic orientation film to be obtained.

In the above explanation, the inorganic orientation film 3A is formed. It is possible to form the inorganic orientation film 4A in the same manner.

Next, a method of forming an inorganic orientation film of a second embodiment of the present invention will be explained.

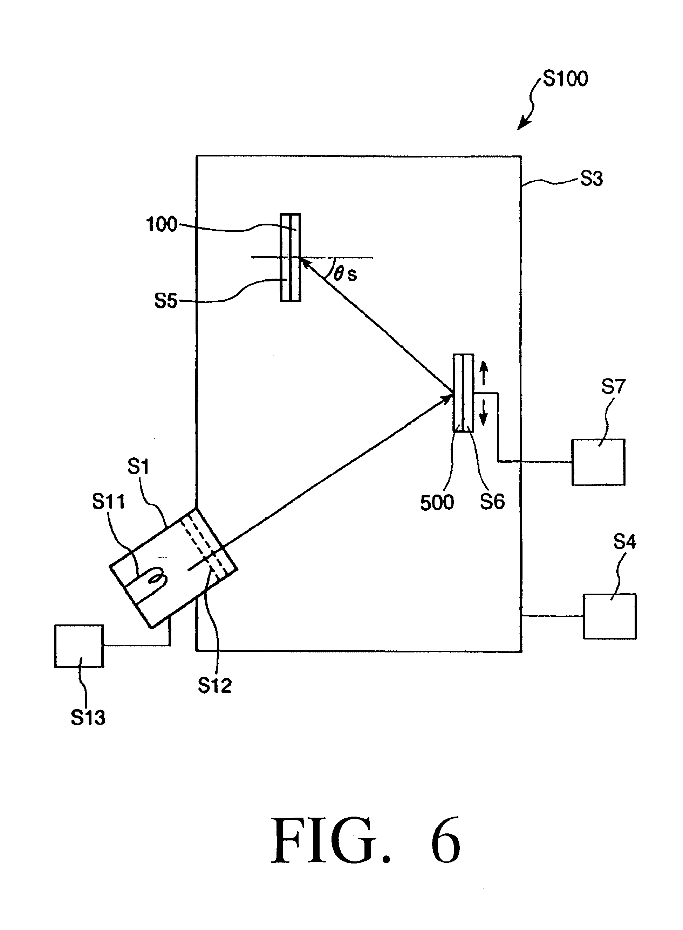

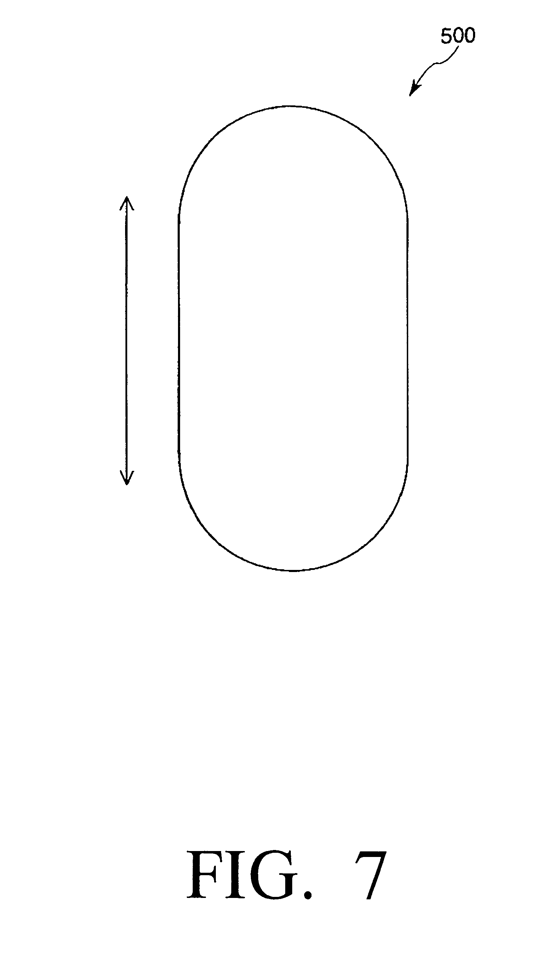

Fig. 6 is a schematic diagram of an orientation film forming apparatus used for the method of forming an inorganic orientation film of the second embodiment of the present invention. Fig. 7 is a diagram for showing a shape of a target used in this embodiment and a moving direction of the target.

First, the orientation film forming apparatus used in this embodiment will be explained.

The orientation film forming apparatus S100 shown in Fig. 6 includes an ion source (an ion beam source) S1 that irradiates ion beams, a vacuum chamber S3, an exhaust pump S4 that controls a pressure in the vacuum chamber S3, a matrix holder S5 that fixes a matrix, on which an inorganic orientation film is to be formed, in the vacuum chamber S3, a target holding member (a backing plate) S6 that holds a target 500, and a moving unit S7 that moves the target 500 together with the target holding member S6.

The ion source S1 includes a filament S11 and lead-out electrodes S12. A gas supply source S13 that supplies gas into the ion source S1 is connected to the ion source S1.

The target holding member S6 is usually formed of a metal material excellent in thermal conductivity such as stainless steel, copper, copper alloy, or the like. When an inorganic orientation film is formed, the target 500 is fixed to the target holding member S6 via a bonding agent of In or the like. The target holding member S6 is made movable by the moving unit S7. Consequently, target 500 also moves together with the target holding member S6. In other words, it is possible to change an irradiation position of ion beams on the target 500 with time. Further, the target 500 is made movable relatively to the ion source S1 and the matrix by the moving unit S7.

The method of forming an inorganic orientation film in the second embodiment of the present invention using the orientation film forming apparatus having the structure shown in the figure will be explained. Hereinbelow, a description will be made with regard to a representative case where the inorganic orientation film 3A is to be formed.
<1> First, the target 500 is set in the target holding member S6 in the vacuum chamber S3. A material forming the target 500 is appropriately selected according to a material forming the inorganic orientation film 3A. For example, in the case where an inorganic orientation film is formed of SiO₂, it is preferred that the target 500 is also formed of SiO₂. Further, in the case where an inorganic orientation film is formed of SiO, it is preferred that the target 500 is also formed of SiO.
<2> Next, the matrix 100 is set on the matrix holder S5 in the vacuum chamber S3.
<3> Next, the vacuum chamber S3 is decompressed by the exhaust pump S4.
<4> Next, gas is supplied into the ion source S1 from the gas supply source S13.
<5> Next, a voltage is applied to the filament S11 from a power supply (not shown in the figure) to generate thermal electrons. The thermal electrons generated in this way collide with the gas led into the ion source S1. Consequently, the gas ionizes to generate plasma. In such a state, an ion acceleration voltage is applied to the lead-out electrodes S12 to accelerate ions and irradiate the target with the ions in the form of ion beams.

Sputter particles are led out from the target 500 on which the ion beams are irradiated. The sputter particles are made incidence and deposited on the matrix 100.

In this case, the target holding member S6 is moved by the moving unit S7. Consequently, an irradiation position of the ion beams on the target 500 changes with time. In other words, the target 500 moves together with the target holding member S6 and a positional relation of the target 500 relative to the ion source S1 and the matrix 100 changes with time (see Fig. 7).

In this way, in this second embodiment, the repair processing is performed for the target 500 which is adapted to be moved relative to the ion source S1 and the matrix 100 while being irradiated with the ion beams. This makes it possible to change, with time, a portion on the target 500 on which the ion beams is made incident. As a result, it is possible to prevent the target 500 from being locally consumed and use the target effectively without waste. Therefore, it is possible to form an inorganic orientation film with a method that saves resources and gives fewer burdens on an environment. Further, it is possible to reduce frequency of replacement of the target 500 and effectively prevent occurrence of problems involved in the replacement of the target.

As shown in Fig. 7, in this embodiment, a target having an elliptical shape is used as the target 500. The relative movement of the target 500 (the movement relative to the ion source S1 and the matrix 100) is a reciprocating movement in one-dimensional direction substantially identical with a major axis direction of the target 500. This makes it possible to effectively use the target 500 sufficiently while preventing the orientation film forming apparatus from being increased in size and complicated.

Moving speed of the target 500 (moving speed relative to the ion source S1 and the matrix 100) is preferably 0.01 to 40mm/second, more preferably 3 to 35mm/second, and still more preferably 3 to 30mm/second. When the moving speed of the target 500 is less than the lower limit value, depending on irradiation conditions or the like of the ion beams, it is likely that an effect obtained by moving the target 500 relative to the ion source S1 and the matrix 100 is not sufficiently exhibited. Depending on the irradiation conditions or the like of the ion beams, it is likely that a flying direction of the sputter particles led out from the target 500 fluctuates to make it difficult to obtain an inorganic orientation film as a film formed of columnar crystals described later. On the other hand, when the moving speed of the target 500 exceeds the upper limit value, depending on the irradiation conditions or the like of the ion beams, it is also likely that a flying direction of the sputter particles led out from the target 500 fluctuates to make it difficult to obtain an inorganic orientation film as a film formed of columnar crystals described later.

When the irradiation of the ion beams involving the movement of the target 500 is continued, deposition of the sputter particles on the matrix 100 progress. As a result, a substrate (the substrate for electronic devices of the present invention (the substrate 200 for electronic devices)) in which the inorganic orientation film 3A is formed on the matrix 100 is obtained.

When the ion beams are irradiated, it is preferable to set a setting angle of the matrix holder S5 to make sputter particles generated from the target 500 incident on the matrix 100 from a direction tilted by a predetermined angle (an irradiation angle) θs with respect to the vertical direction of the surface forming the inorganic orientation film 3A. This makes it possible to form an inorganic orientation film in which columnar crystals mainly formed of an inorganic material are oriented in a tilted state with respect to a surface of a matrix on which the inorganic orientation film is to be formed. As a result, it is possible to more surely control a pre-tilt angle of the inorganic orientation film, thereby enabling to make orientation characteristic (a function of regulating an orientation state of a liquid crystal material) of the inorganic orientation film particularly excellent.

The angle θs is preferably equal to or larger than 40°, more preferably equal to or larger than 45°, still more preferably 50 to 87°, and even more preferably 70 to 87°. This makes it possible to form a shape near the vertexes of the columnar crystals forming the inorganic orientation film 3A as a shape that makes it possible to more stably orient liquid crystal molecules. As a result, the inorganic orientation film 3A to be obtained has a more excellent function of regulating an orientation state of liquid crystal molecules. When the angle θs is too small, a sufficient pre-tilt angle is not obtained, and thus it is likely that the function of regulating an orientation state of liquid crystal molecules is not sufficiently obtained. On the other hand, when the angle θs is too large, it is difficult to surely deposit sputter particles led out from the target 500 on the matrix 100. As a result, it is likely that adhesiveness between the matrix 100 and the inorganic orientation film 3A is deteriorated.

The inventor has found that it is possible to suitably control an orientation characteristic of an inorganic orientation film by controlling energy and/or the number of sputter particles that reach a matrix when film formation is performed as described above. More specifically, by controlling energy and/or the number of sputter particles that reach the matrix, it is possible to form a shape near the vertexes of the columnar crystals forming the inorganic orientation film 3A as a shape that makes it possible to more stably orient liquid crystal materials. As a result, it is possible to further improve the orientation characteristic of the inorganic orientation film.

Moreover, it is preferable that at least one of conditions (1) and (2) below is satisfied, and it is more preferable that the two conditions are simultaneously satisfied.
(1) An acceleration voltage of ion beams applied to the lead-out electrodes S12 is equal to or higher than 1200V.
(2) An ion beam current of ion beams irradiated is 50 to 500mA.

By satisfying at least one of the conditions (1) and (2), it is possible to form a shape near the vertexes of the columnar crystals forming the inorganic orientation film as a shape that makes it possible to more stably orient liquid crystal molecules. As a result, it is possible to more surely control a pre-tilt angle.

In particular, the effects described above become more conspicuous when the conditions (1) and (2) are simultaneously satisfied.

As described above, an acceleration voltage of ion beams is preferably equal to or higher than 1200V. More preferably, the acceleration voltage is equal to or higher than 1400V. When the acceleration voltage is lower than the lower limit value, it may be difficult to surely control a shape near the vertexes of the columnar crystals.

As described above, an ion beam current is preferably 50 to 500mA. More preferably, the ion beam current is 200 to 500mA. When the ion beam current is less than the lower limit value, a sputter rate decreases and sufficient productivity is not obtained in some cases. On the other hand, the ion beam current exceeds the upper limit value, fluctuation tends to occur in an orientation characteristic of liquid crystal molecules.

In general, when sputter particles are made incident on a matrix in a tilted state under predetermined conditions, it is possible to grow columnar crystals tilted in a direction corresponding to an incidence angle (an irradiation angle) of the sputter particles, thereby enabling an inorganic orientation film as a whole to have an orientation characteristic. However, it is likely that fluctuation occurs in an orientation characteristic of liquid crystal molecules. In this embodiment, when the conditions described above are satisfied, it is possible to control a shape near the vertexes of the columnar crystals forming the inorganic orientation film 3A to be a shape that makes it possible to stably orient liquid crystal molecules. As a result, it is possible to more surely control a pre-tile angle.

A pressure in the vacuum chamber S3, that is, a pressure of the atmosphere in forming the inorganic orientation film 3A is preferably equal to or lower than 5.0×10⁻²Pa and more preferably equal to or lower than 1.0×10⁻²Pa. This makes it possible to form the inorganic orientation film 3A in which liquid crystal molecules can be more stably orientated. On the other hand, when the pressure in the vacuum chamber S3 is too high, linearity of sputter particles may be deteriorated. As a result, it is likely that columnar crystals are not sufficiently formed. Further, it is also likely that orientations of crystals are not sufficiently aligned.

Gas supplied into the ion source S1 from the gas supply source S13 is not specifically limited. However, the gas is preferably a rare gas and more preferably an argon gas. This makes it possible to improve a formation speed (a sputter rate) of the inorganic orientation film 3A.

Temperature of the matrix 100 in forming the inorganic orientation film 3A is preferably relatively low. Specifically, the temperature of the matrix 100 is preferably set to be equal to or lower than 150°C, more preferably set to be equal to or lower than 80°C, and still more preferably set to be 20 to 50°C. This makes it possible to control a phenomenon in which sputter particles adhering to the matrix 100 move from a position where the sputter particles adhere to the matrix 100 first, that is, a phenomenon called migration, thereby enabling to form the inorganic orientation film 3A in which liquid crystal molecules can be more stably oriented. The matrix 100 may be cooled as required such that temperature of the matrix 100 in forming the inorganic orientation film 3A is within the range described above.

A formation speed (a film formation speed) of the inorganic orientation film 3A is not specifically limited. However, the formation speed is preferably 1 to 15nm/minute and more preferably 6 to 10nm/minute. This makes it possible to more efficiently form an inorganic orientation film without spoiling an orientation characteristic of the inorganic orientation film to be obtained.

In the above explanation, the inorganic orientation film 3A is formed. It is possible to form the inorganic orientation film 4A in the same manner.

Next, a liquid crystal panel of the second embodiment of the present invention will be explained.

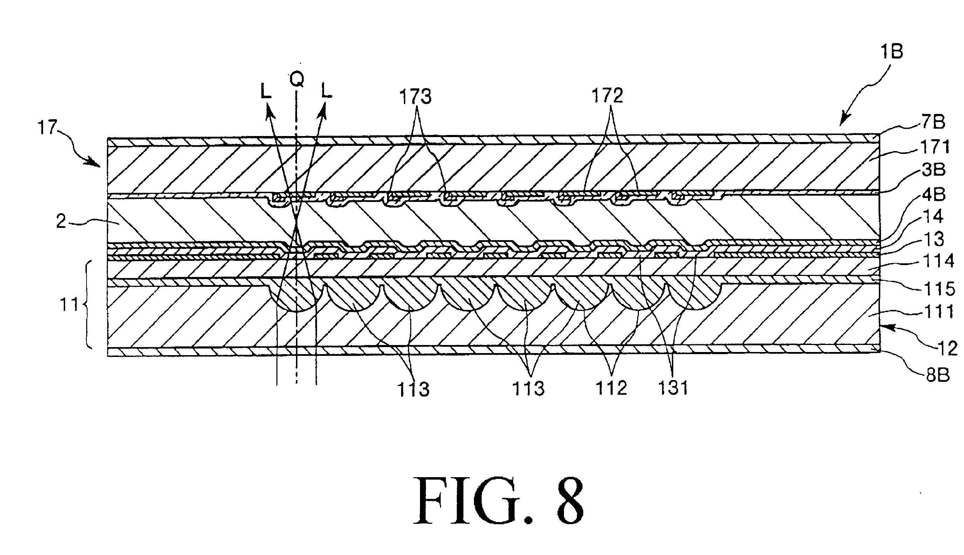

Fig. 8 is a schematic longitudinal sectional view showing the liquid crystal panel in the second embodiment of the present invention. Differences of a liquid crystal panel 1B shown in Fig. 8 from the liquid crystal panel in the first embodiment will be mainly explained below, and explanations on the matters same as those in the first embodiment will be omitted.

As shown in Fig. 8, a liquid crystal panel (a TFT liquid crystal panel) 1B includes a TFT substrate (a liquid crystal driving substrate) 17, an inorganic orientation film 3B joined to the TFT substrate 17, an opposed substrate for liquid crystal panels 12, an inorganic orientation film 4B joined to the opposed substrate for liquid crystal panels 12, a liquid crystal layer 2 consisting of liquid crystal filled in a gap between the inorganic orientation film 3B and the inorganic orientation film 4B, a polarizing film 7B joined to an outer surface of the TFT substrate (the liquid crystal driving substrate) 17, that is a surface of the TFT substrate 17 which is opposite to a surface thereof which faces the inorganic orientation film 3B, and a polarizing film 8B joined to an outer surface of the opposed substrate for liquid crystal panels 12, that is a surface of the opposed substrate for liquid crystal panels 12 which is opposite to a surface thereof which faces the inorganic orientation film 4B. The inorganic orientation films 3B and 4B are formed by a method same as the method of forming the inorganic orientation films 3A and 4A described above (the method of forming an inorganic orientation film of the present invention). The polarizing films 7B and 8B are the same as the polarizing films 7A and 8A, respectively.

The opposed substrate for liquid crystal panels 12 includes a microlens substrate 11, a black matrix 13 that is provided on a surface layer 114 of the microlens substrate 11 and in which openings 131 are formed, and a transparent conductive film (a common electrode) 14 that is provided on the surface layer 114 to cover the black matrix 13.

The microlens substrate 11 includes a substrate with concave portions for microlenses (a first substrate) 111 in which a plurality of (a large number of) concave portions (concave portions for microlenses) each having a concaved curved surfaced are formed and the surface layer (a second substrate) 114 that is joined to, via a resin layer (an adhesive layer) 115, a surface of the substrate with concave portions for microlenses 111 in which the concave portions 112 are provided. In the resin layer 115, microlenses 113 are formed with resin filled in the concave portions 112.

The substrate with concave portions for microlenses 111 is manufactured from a planar base material (transparent substrate). The plural (large number of) concave portions 112 are formed on a surface of the substrate with concave portions for microlenses 111. It is possible to form the concave portions 112 with a dry etching method, a wet etching method, or the like using a mask.

The substrate with concave portions for microlenses 111 is formed of glass or the like.

A coefficient of thermal expansion of the base material is preferably substantially equal to a coefficient of thermal expansion of a glass substrate 171 (e.g., a ratio of the coefficients of thermal expansion of the base material and the glass substrate 171 is about 1/10 to 10). Consequently, in a liquid crystal panel to be obtained, warp, bending, peeling, and the like caused by a difference of the coefficients of thermal expansion when temperature changes can be effectively prevented.

From such a viewpoint, it is preferable that the substrate with concave portions for microlenses 111 and the glass substrate 171 are formed of the same kind of material. Consequently, warp, bending, peeling, and the like caused by a difference of the coefficients of thermal expansion when temperature changes can be effectively prevented.

In particular, when the microlens substrate 11 is used for a TFT liquid crystal panel made of high-temperature polysilicon, the substrate with concave portions for microlenses 111 is preferably formed of quartz glass. The TFT liquid crystal panel has a TFT substrate as a liquid crystal driving substrate. For such a TFT substrate, quartz glass, a characteristic of which less easily changes because of an environment at the time of manufacturing, is preferably used. This makes it possible to obtain a TFT liquid crystal panel having excellent stability, in which warp, bending, and the like less easily occur, by forming the substrate with concave portions for microlenses 111 with quartz glass.

The resin layer (the adhesive layer) 115 covering the concave portions 112 is provided on an upper surface of the substrate with concave portions for microlenses 111.

In the concave portions 112, a material forming the resin layer 115 is filled to form the microlenses 113.

It is possible to form the resin layer 115 from a resin (adhesive) having a refractive index higher than a refractive index of the material forming the substrate with concave portions for microlenses 111. It is possible to suitably form the resin layer 115 with acrylic resin, epoxy resin, ultraviolet curing resin such as acrylic epoxy, or the like.

The planar surface layer, 114 is provided on an upper surface of the resin layer 115.

It is possible to form the surface layer (the glass layer) 114 with glass. In this case, a coefficient of thermal expansion of the surface layer 114 is preferably substantially equal to a coefficient of thermal expansion of the substrate with concave portions for microlenses 111 (e.g., a ratio of the coefficients of thermal expansion of the surface layer 114 and the substrate with concave portions for microlenses 111 is about 1/10 to 10). Consequently, warp, bending, peeling, and the like caused by a difference of the coefficients of thermal expansion between the substrate with concave portions for microlenses 111 and the surface layer 114 can be effectively prevented. Such an effect is more effectively obtained when the substrate with concave portions for microlenses 111 and the surface layer 114 are formed from the same kind of material.

When the microlens substrate 11 is used for a liquid crystal panel, from a viewpoint of obtaining a necessary optical characteristic, thickness of the surface layer 114 is usually set to about 5 to 1000µm and more preferably set to about 10 to 150µm.

It is also possible to form the surface layer (a barrier layer) 114 with ceramics. Examples of ceramics include nitride ceramics such as AlN, SiN, TiN, and BN, oxide ceramics such as Al₂O₃ and TiO₂, and carbide ceramics such as WC, TiC, ZrC, and TaC. When the surface layer 114 is formed of ceramics, thickness of the surface layer 114 is not specifically limited. However, the thickness of the surface layer 114 is preferably set to about 20nm to 20µm and more preferably set to about 40nm to 1µm. In this regard, it is to be noted that such a surface layer 114 may be omitted if it is not necessary.

The black matrix 13 has a light blocking function and is formed of metal such as Cr, Al, Al alloy, Ni, Zn, or Ti or resin in which carbon or titanium are dispersed.

The transparent conductive film 14 has electrical conductivity and is formed of indium tin oxide (ITO), indium oxide (IO), or tin oxide (SnO₂), or the like.

The TFT substrate 17 is a substrate for driving liquid crystal of the liquid crystal layer 2 and includes a glass substrate 171, plural (a large number of) pixel electrodes 172 provided on the glass substrate 171 and disposed in the matrix shape, and plural (a large number of) thin film transistors (TFT) 173 corresponding to the respective pixel electrodes 172. In Fig. 8, a seal material, wiring, and the like are not shown.

Because of the reason described above, the glass substrate 171 is preferably formed of quartz glass.

The pixel electrodes 172 perform charging and discharging between the transparent conductive film (the common electrode) 14 and the pixel electrodes 172 to thereby drive liquid crystal of the liquid crystal layer 2. The pixel electrodes 172 are formed of, for example, a material same as the material of the transparent conductive film 14.

The thin film transistors 173 are connected to the pixel electrodes 172 corresponding to and provided near the thin film transistors 173. The thin film transistors 173 are connected to a control circuit (not shown in the drawings) and controls an electric current supplied to the pixel electrodes 172. Consequently, charging and discharging of the pixel electrodes 172 are controlled.

The inorganic orientation film 3B is joined to the pixel electrodes 172 of the TFT substrate 17. The inorganic orientation film 4B is joined to the transparent conductive film 14 of the opposed substrate for liquid crystal panels 12.

The liquid crystal layer 2 is formed of a liquid crystal material (liquid crystal molecules). An orientation of the liquid crystal molecules, that is, liquid crystal, changes in response to charging and discharging of the pixel electrodes 172.

In such a liquid crystal panel 1B, usually, one microlens 113, one opening 131 of the black matrix 13 corresponding to an optical axis Q of the microlens 113, one pixel electrode 172, and one thin film transistor 173 connected to the pixel electrode 172 correspond to one pixel.

Incident lights L made incident from the side of the opposed substrate for liquid crystal panels 12 pass through the substrate with concave portions for microlenses 111 and are transmitted through the resin layer 115, the surface layer 114, the openings 131 of the black matrix 13, the transparent conductive film 14, the liquid crystal layer 2, the pixel electrode 172, and the glass substrate 171 while being condensed when the incident lights L pass through the microlenses 113. At this point, since the polarizing film 8B is provided on the incidence side of the microlens substrate 11, when the incident lights L are transmitted through the liquid crystal layer 2, the incident lights change to linear polarized lights. In that case, a polarizing direction of the incident lights L is controlled in association with an orientation state of the liquid crystal molecules of the liquid crystal layer 2. Therefore, it is possible to control luminance of emitted lights by transmitting the incident lights L, which are transmitted through the liquid crystal panel 1B, through the polarizing film 7B.

As described above, the liquid crystal panel 1B has the microlenses 113, and the incident lights L having passed through the microlenses 113 are condensed and pass through the openings 131 of the black matrix 13. On the other hand, in portions of the black matrix 13 where the openings 131 are not formed, the incident lights L are blocked. Therefore, in the liquid crystal panel 1B, unnecessary light is prevented from leaking from portions other than the pixels and attenuation of the incident lights L in the pixel portions is controlled. Therefore, the liquid crystal panel 1B has a high light transmittance in the pixel portions.

It is possible to manufacture the liquid crystal panel 1B by forming the inorganic orientation films 3B and 4B on the TFT substrate 17 and the opposed substrate for liquid crystal panels 12 manufactured by the known method, respectively, and, then, joining the TFT substrate 17 and the opposed substrate for liquid crystal panels 12 via a seal material (not shown in the figure), injecting liquid crystal into a gap portion formed by the joining of the TFT substrate 17 and the opposed substrate for liquid crystal panels 12 from filling holes (not shown in the figure) of the gap portion, and then closing the filling holes.

In the liquid crystal panel 1B, the TFT substrate is used as the liquid crystal driving substrate. However, liquid crystal driving substrates other than the TFT substrate such as a TFD substrate, an STN substrate, and the like may be used for the liquid crystal driving substrate.

The liquid crystal panel including the inorganic orientation film as described above may be suitably used for a liquid crystal panel having a strong light source and a liquid crystal panel for outdoor use.

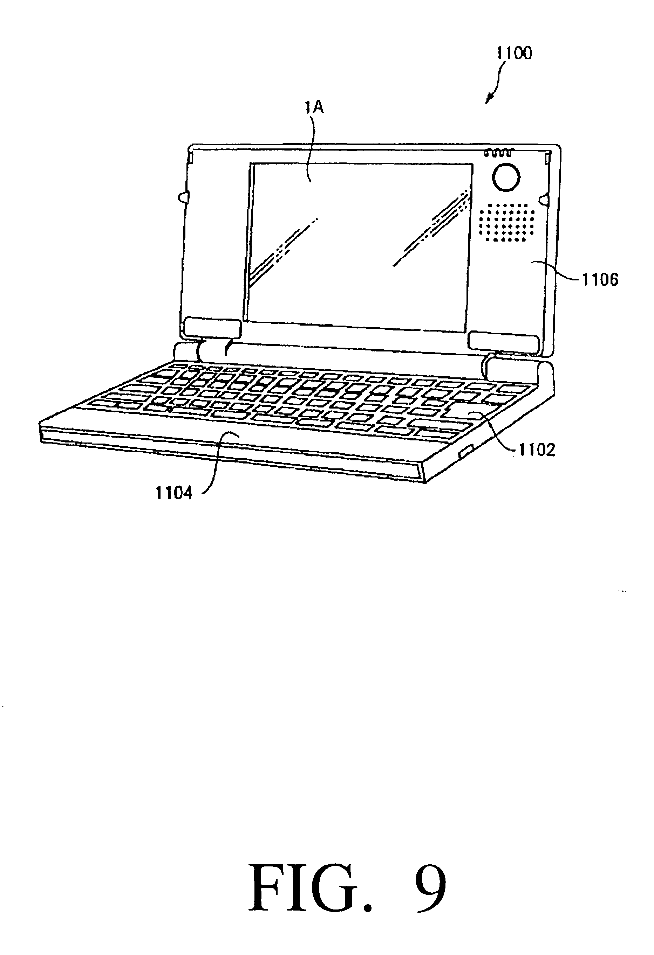

Electronic equipment (a liquid crystal display device) including the liquid crystal panel 1A described above will be explained in detail on the basis of embodiments shown in Figs. 9 to 11.

Fig. 9 is a perspective view of a personal computer of a mobile type (or a notebook type) to which the electronic equipment of the present invention is applied.

In the figure, a personal computer 1100 includes a main body unit 1104, which includes a keyboard 1102, and a display unit 1106. The display unit 1106 is supported to be capable of moving rotationally relative to the main body unit 1104 via a hinge structure.

In the personal computer 1100, the display unit 1106 includes the liquid crystal panel 1A and a backlight not shown in the drawing. It is possible to display an image (information) by transmitting light from the backlight through the liquid crystal panel 1A.

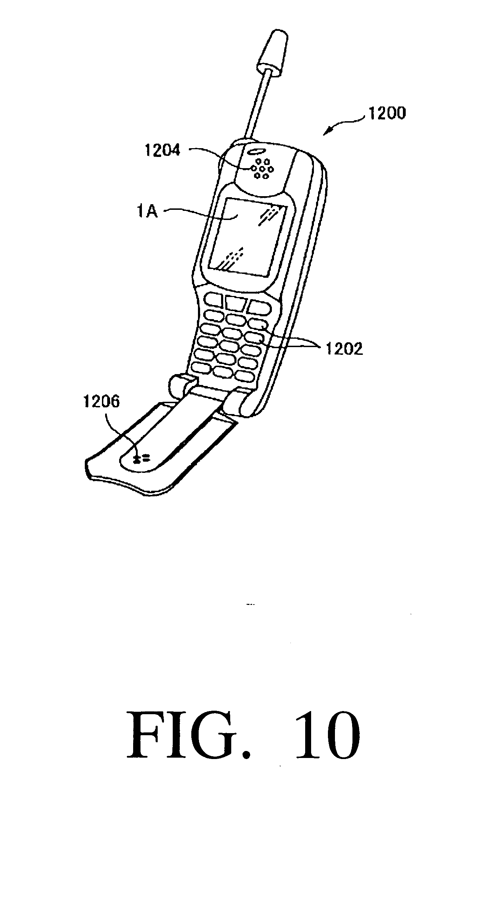

Fig. 10 is a perspective view of a cellular phone (including a Personal Handy-Phone System (PHS)) to which the electronic equipment of the present invention is applied.

In the figure, a cellular phone 1200 includes a plurality of operation buttons 1202, an earpiece 1204, and a mouthpiece 1206 as well as the liquid crystal panel 1A and a backlight not shown in the drawing.

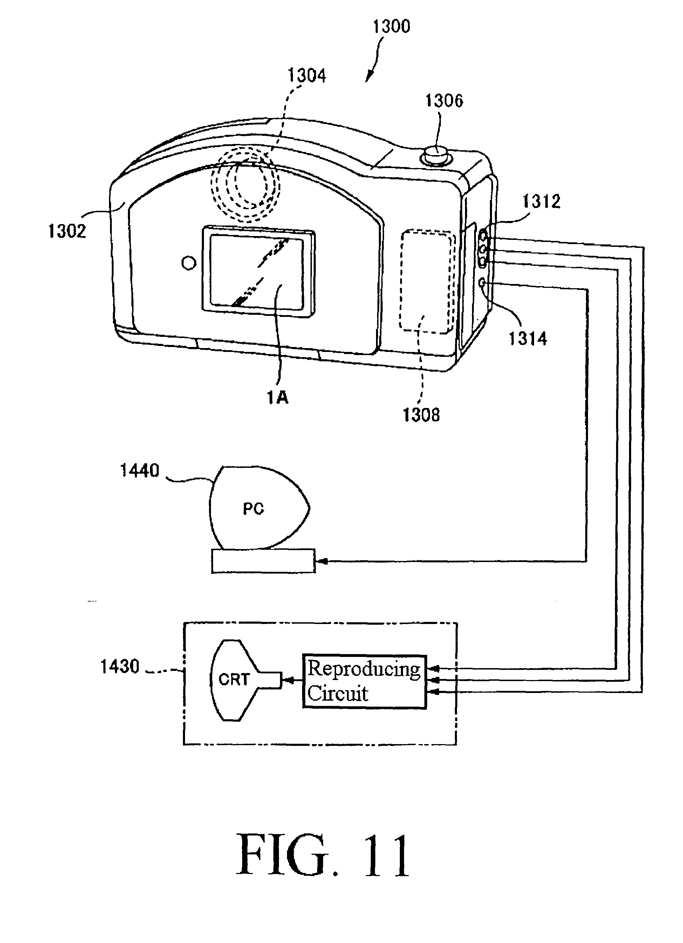

Fig. 11 is a perspective view of a digital still camera to which the electronic equipment of the present invention is applied. In the figure, connection to an external apparatuses is also briefly shown.

A usual camera exposes a silver salt photograph film with an optical image of a subject. On the other hand, a digital still camera 1300 photoelectrically converts an optical image of a subject with an imaging device such as a Charge Coupled Device (CCD) to generate an imaging signal (an image signal).

The liquid crystal panel 1A and a backlight (not shown in the drawing) are provided on a rear surface of a case (a body) 1302 in the digital still camera 1300. The digital still camera 1300 performs display on the basis of the imaging signal generated by the CCD. The liquid crystal panel 1A functions as a finder for displaying a subject as an electronic image.

A circuit board 1308 is set inside the case. A memory that can store the imaging signal is set on the circuit board 1308.

A light-receiving unit 1304 including an optical lens (an imaging optical system), a CCD, and the like is provided on a front side of the case 1302 (in the structure shown in the figure, on a rear side).

When a photographer checks a subject image displayed on the liquid crystal panel 1A and depresses a shutter button 1306, an imaging signal of the CCD at that point is transferred to and stored in the memory of the circuit board 1308.

In the digital still camera 1300, a video signal output terminal 1312 and an input/output terminal 1314 for data communication are provided on a side of the case 1302. As shown in the figure, a television monitor 1430 and a personal computer 1440 are connected to the video signal output terminal 1312 and the input/output terminal 1314 for data communication, respectively, as required. Moreover, the imaging signal stored in the memory of the circuit board 1308 is outputted to the television monitor 1430 and the personal computer 1440 according to predetermined operation.

Next, as an example of the electronic equipment of the present invention, an electronic equipment (a liquid crystal projector) using the liquid crystal panel 1B will be explained.

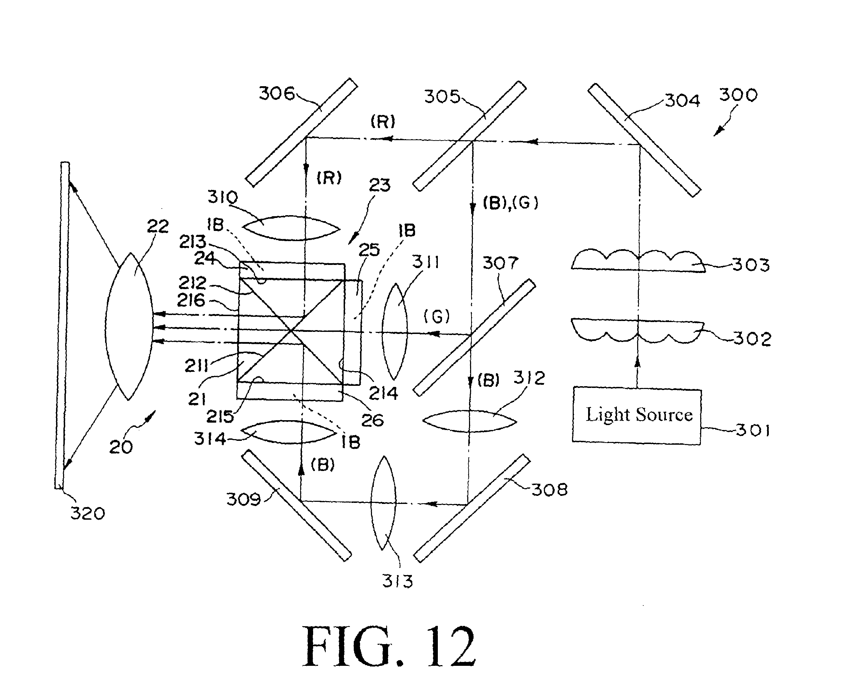

Fig. 12 is a diagram schematically showing an optical system of an electronic equipment (a projection type display apparatus) of the present invention.

As shown in the figure, a projection type display apparatus 300 includes a light source 301, a lighting optical system including plural integrator lenses, a color separation optical system (a light guiding optical system) including plural dichroic mirrors and the like, a liquid crystal light valve (a liquid crystal light shutter array) (for red) 24 corresponding to a red color, a liquid crystal light valve (a liquid crystal light shutter array) (for green) 25 corresponding to a green color, a liquid crystal light valve (a liquid crystal light shutter array) (for blue) 26 corresponding to a blue color, a dichroic prism (a color combining optical system) 21 on which a dichroic mirror surface 211 for reflecting only red light and a dichroic mirror surface 212 for reflecting only blue light are formed, and a projection lens (a projection optical system) 22.

The lighting optical system includes integrator lenses 302 and 303. The color separating optical system includes mirrors 304, 306, and 309, a dichroic mirror 305 that reflects blue light and green light (transmits only red light), a dichroic mirror 307 that reflects only green light, a dichroic mirror 308 that reflects only blue light (or a mirror that reflects blue light), and condensing lenses 310, 311, 312, 313, and 314.

The liquid crystal light valve 25 includes the liquid crystal panel 1B. The liquid crystal light valves 24 and 26 have the same structure as the liquid crystal light valve 25. The liquid crystal panels 1B included in the liquid crystal light valves 24, 25, and 26 are respectively connected to a driving circuit (not shown in the drawing).

In the projection type display apparatus 300, the dichroic prism 21 and the projection lens 22 constitute an optical block 20. The optical block 20 and the liquid crystal light valves 24, 25, and 26 fixedly provided on the dichroic prism 21 constitute a display unit 23.

Hereinafter, operations of the projection type display apparatus 300 will be explained.

White light (a white light beam) emitted from the light source 301 is transmitted through the integrator lenses 302 and 303. A light intensity (a luminance distribution) of this white light is uniformalized by the integrator lenses 302 and 302. In this case, it is preferable that the white light emitted from the light source 301 is white light having a relatively large light intensity. This makes it possible to make an image formed on a screen 320 more clear. In the projection type display apparatus 300, since the liquid crystal panel 1B having excellent light resistance is used, superior long-term stability is obtained even when an intensity of light emitted from the light source 301 is large.

The white light transmitted through the integrator lenses 302 and 303 is reflected to the left side in Fig. 12 by the mirror 304. Blue light (B) and green light (G) in the reflected light are reflected to the lower side in Fig. 12 by the dichroic mirror 305 and red light (R) in the reflected light is transmitted through the dichroic mirror 305.

The red light transmitted through the dichroic mirror 305 is reflected to the lower side in Fig. 12 by the mirror 306. The reflected light is shaped by the condensing lens 310 to be made incident on the liquid crystal light valve for red 24.

The green light in the blue light and the green light reflected by the dichroic mirror 305 is reflected to the left side in Fig. 12 by the dichroic mirror 307. The blue light is transmitted through the dichroic mirror 307.

The green light reflected by the dichroic mirror 307 is shaped by the condensing lens 311 and made incident on the liquid crystal light valve for green 25.

The blue light transmitted through the dichroic mirror 307 is reflected to the left side in Fig. 12 by the dichroic mirror (or the mirror) 308. The reflected light is reflected to the upper side in Fig. 12 by the mirror 309. The blue light is shaped by the condensing lenses 312, 313, and 314 and made incident on the liquid crystal light valve for blue 26.

In this way, the white light emitted from the light source 301 is separated into three primary colors of red, green, and blue, guided to the liquid crystal light valves corresponding thereto, respectively, and made incident thereon.

In this case, respective pixels (the thin film transistors 173 and the pixel electrodes 172 connected thereto) of the liquid crystal panel 1B included in the liquid light valve 24 are subjected to switching control (ON/OFF), that is, modulated by a driving circuit (a driving unit) that operates on the basis of an image signal for red.

Similarly, the green light and the blue light are made incident on the liquid crystal light valves 25 and 26, respectively, and modulated by the respective liquid crystal panels 1B. Consequently, an image for green and an image for blue are formed. In this case, respective pixels of the liquid crystal panel 1B included in the liquid crystal light valve 25 are subjected to switching control by a driving circuit that operates on the basis of an image signal for green. Respective pixels of the liquid crystal panel 1B included in the liquid crystal light valve 26 are subjected to switching control by a driving circuit that operates on the basis of an image signal for blue.

Consequently, the red light, the green light, and the blue light are modulated by the liquid crystal light valves 24, 25, and 26, respectively, and an image for red, an image for green, and an image for blue are formed.

The image for red formed by the liquid crystal light valve 24, that is, the red light from the liquid crystal light valve 24 is made incident on the dichroic prism 21 from a surface 213, reflected to the left side in Fig. 12 on the dichroic mirror surface 211, transmitted through the dichroic mirror surface 212, and then emitted from an emission surface 216.

The image for green formed by the liquid crystal light valve 25, that is, the green light from the liquid crystal light valve 25 is made incident on the dichroic prism 21 from a surface 214, transmitted through the dichroic mirror surfaces 211 and 212, and then emitted from the emission surface 216.

The image for blue formed by the liquid crystal light valve 26, that is, the blue light from the liquid crystal light valve 26 is made incident on the dichroic prism 21 from a surface 215, reflected to the left side in Fig. 12 on the dichroic mirror surface 212, transmitted through the dichroic mirror surface 211, and then emitted from the emission surface 216.

In this way, the lights of the respective colors from the liquid crystal light valves 24, 25, and 26, that is, the respective images formed by the liquid crystal light valves 24, 25, and 26 are combined by the dichroic prism 21. Consequently, a color image is formed. This image is projected (magnified and projected) on the screen 320 set in a predetermined position by the projection lens 22.

In addition to the personal computer (the mobile personal computer) in Fig. 9, the cellular phone in Fig. 10, the digital still camera in Fig. 11, and the projection type display apparatus in Fig. 12 described above, examples of the electronic equipment of the present invention include a television, a video camera, viewfinder type and monitor direct-view type video tape recorders, a car navigation device, a pager, an electronic notebook (including an electronic notebook with a communication function), an electronic dictionary, an electronic calculator, an electronic game device, a word processor, a workstation, a television telephone, a television monitor for crime prevention, an electronic binocular, a POS terminal, devices including a touch panel (e.g., a cash dispenser in a financial institution and an automatic ticket vending machine), medical devices (e.g., an electronic thermometer, a blood pressure meter, a blood glucose meter, an electrocardiographic display device, an ultrasonic diagnostic device, and for an endoscope), a fish finder, various measurement devices, meters (e.g., meters for a vehicle, an airplane, and a ship), and a flight simulator. It goes without saying that the liquid crystal panel of the present invention is applicable as display units and monitor units for these various electronic devices and equipment.

The present invention has been explained on the basis of the embodiments shown in the figures. However, the present invention is not limited to the embodiments.

For example, in the method of forming an inorganic orientation film of the present invention, one or two or more arbitrary aimed steps may be added. Further, for example, in the substrate for electronic devices, the liquid crystal panel, and the electronic equipment of the present invention, the structures of the respective units or components may be replaced with arbitrary structures that exhibit the same functions. Further, it is also possible to add arbitrary structures.

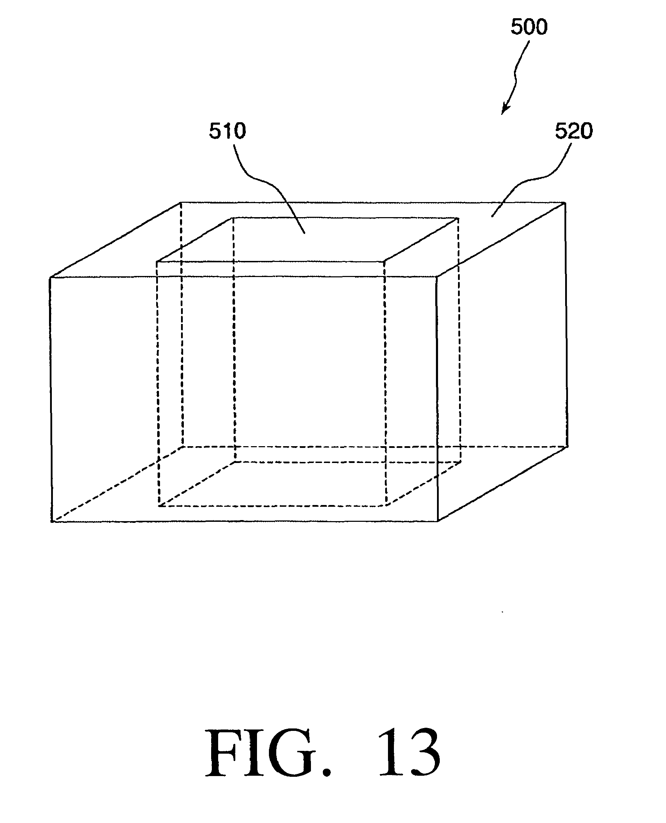

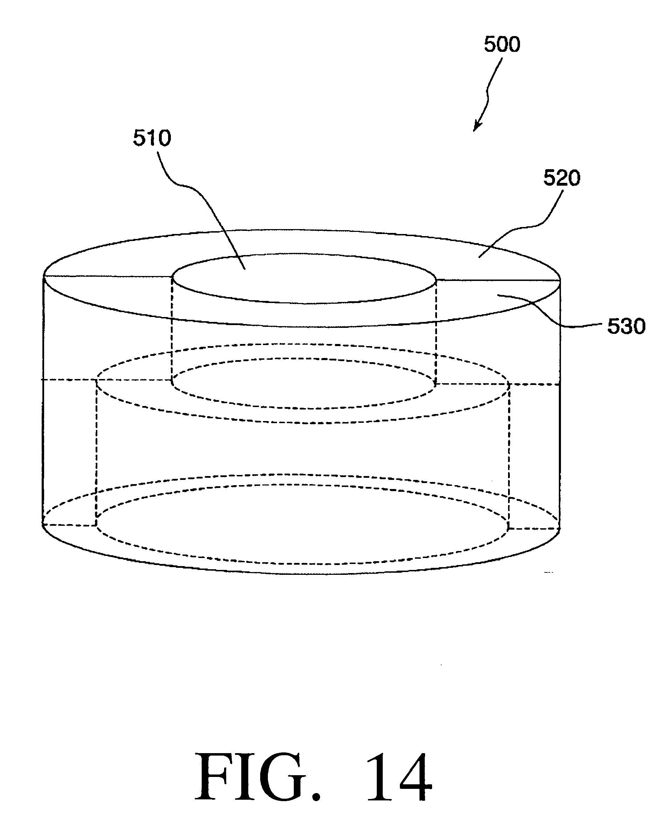

In the explanation of the first embodiment, the target is constituted by concentrically arranging plural members (columnar and cylindrical members). However, shapes and arrangement patterns of the members forming the target are not limited to those described above. For example, as shown in Fig. 13, the target 500 may be formed of members having a prismatic shape and a square tube shape. Further, as shown in Fig. 14, the target 500 may include members, which have a U-shaped half tube shape in a plan view, as the second member 520 and the third member 530. This makes it possible to easily replace the first member 510.

The target may be formed by integrating plural members by joining them. Even if the target is formed in this way, when necessary, it is possible to selectively replace only a predetermined member (e.g., the first member) forming the target.

In the explanation of the second embodiment, in irradiating ion beams, the target is moved in the one-dimensional direction. However, the target may be moved in two or more dimensional directions.

In the explanation of the second embodiment, the target has the elliptical shape. However, a size of the target is not specifically limited.

In the explanation of the second embodiment, the projection type display apparatus (the electronic device) has the three liquid crystal panels and the liquid crystal panel of the present invention is applied to all of these liquid crystal panels. However, it is sufficient that at least one of the liquid crystal panels is constituted from the liquid crystal panel of the present invention. In this case, it is preferable to apply the present invention to the liquid crystal panel used for the liquid crystal light valve for blue.

### EXAMPLES

### <Manufacturing of a liquid crystal panel>

The liquid crystal panel shown in Fig. 8 was manufactured as described blow.

### (Example 1)

First, a microlens substrate was manufactured as described below.

An unprocessed quartz glass substrate (a transparent substrate) with thickness of about 1.2mm was prepared, and then it was immersed in a cleaning liquid (a mixed liquid of sulfuric acid and hydrogen peroxide water) at temperature of 85°C and cleaned. In this way, a surface of the quartz glass substrate was purified.

Thereafter, films of polysilicon with thickness of 0.4µm were formed by the CVD method on the surface and a rear surface of the quartz glass substrate, respectively.

Subsequently, openings corresponding to concave portions to be formed were formed in the thus formed polysilicon films.

This was performed as described below. Fist, resist layers having patterns of the concave portions to be formed were formed on the polysilicon films. Subsequently, dry etching with a CF gas was carried out to the polysilicon films to form the openings. The resist layers were removed.

Subsequently, the quartz glass substrate was immersed in an etching liquid (a mixed water solution of 10wt% of fluoric acid + 10wt% of glycerin) for 120 minutes and wet etching (at an etching temperature of 30°C) was performed to form the concave portions on the quartz glass substrate.

Thereafter, the quartz glass substrate was immersed in 15wt% of a tetramethyl ammonium hydroxide water solution to remove the polysilicon films formed on the surface and the rear surface. Consequently, a substrate with concave portions for microlenses was obtained.

Subsequently, an ultraviolet (UV) curing acrylic optical adhesive (with a refractive index of 1.60) was applied, without bubbles, to the surface of the substrate with concave portions for microlenses in which the concave portions were formed. Cover glass (a surface layer) made of quartz glass was joined to the optical adhesive. An ultraviolet ray was irradiated on the optical adhesive to harden the optical adhesive. Consequently, a laminated member was obtained.

Thereafter, the cover glass was grinded and abraded to have thickness of 50µm. Consequently, a microlens substrate was obtained.

In the thus obtained microlens substrate, thickness of a resin layer was 12µm.

For the microlens substrate obtained as described above, a light blocking film (a Cr film), that is, a black matrix, with thickness of 0.16µm provided with openings in positions corresponding to the microlenses of the cover glass was formed using the sputtering method and the photolithography method. Moreover, an ITO film (a transparent conductive film) with thickness of 0.15µm was formed on the black matrix by the sputtering method to manufacture an opposed substrate for liquid crystal panels.

An inorganic orientation film was formed on the transparent conductive film of the opposed substrate for liquid crystal panels obtained in this way using the apparatus shown in Fig. 3 as described below.

First, the target 500 made of SiO₂ having the shape shown in Fig. 4 was set in the target holding member S6 formed of copper via In serving as a bonding agent. The first member 510 forming the target 500 had a columnar shape with diameter of 50mm and height of 2mm. The second member 520 had a cylindrical shape with an external diameter of 300mm, an inner diameter of 50mm in a portion in contact with the first member 510, an inner diameter of 150mm in a portion in contact with the target holding member S6 (the bonding agent), and height of 3mm.

Subsequently, the opposed substrate for liquid crystal panels was set on the matrix holder S5 in the vacuum chamber S3 and the vacuum chamber S3 was decompressed to 7.0×10⁻⁵Pa by the exhaust pump S4.

An argon gas was supplied into the ion source S1 from the gas supply source S13 and a voltage was applied to the filament S11 to generate plasma. An ion acceleration voltage of 1800V was applied to the lead-out electrodes S12 to accelerate ions. The ions were irradiated on the target 500 as ion beams. An ion beam current of the ion beam irradiated was 250mA.

Sputter particles were led out from the target 500, on which the ion beams were irradiated, to the opposed substrate for liquid crystal panels. An inorganic orientation film formed of SiO₂ with an average thickness of 0.05µm was formed on the transparent conductive film. The irradiation angle (the incidence angle) θs of the sputter particles was 80°. Temperature of the opposed substrate for liquid crystal panels in forming a film was 100°C.

The tilt angle θc of columnar crystals forming the inorganic orientation film formed as described above with respect to the opposed substrate for liquid crystal panels was 45° and width of each columnar crystal was 25nm.

In the same manner, an inorganic orientation film was also formed on a surface of a TFT substrate (made of quartz glass) separately prepared.

The opposed substrate for liquid crystal panels on which the inorganic orientation film was formed and the TFT substrate on which the inorganic orientation film was formed were joined via a seal material. This joining was performed to shift orientation directions of the inorganic orientation films by 90° such that liquid crystal molecules forming the liquid crystal layer were twisted to the left.

### Subsequently, liquid crystal (manufactured by Merk Ltd.:

MJ99247) was injected into a gap portion formed between the inorganic orientation films from filling holes of the gap portion. Then, the filling holes were closed. Thickness of the liquid crystal layer formed was about 3µm.

Thereafter, a TFT liquid crystal panel having the structure shown in Fig. 8 was manufactured by joining the polarizing film 8B and the polarizing film 7B on an outer surface of the opposed substrate for liquid crystal panels and an outer surface of the TFT substrate, respectively. As the polarizing films, a polarizing film obtained by extending a film formed of polyvinyl alcohol (PVA) in a uniaxial direction was used. Joining directions of the polarizing film 7B and the polarizing film 8B were determined on the basis of the orientation directions of the inorganic orientation film 3B and the inorganic orientation film 4B, respectively. The polarizing film 7B and the polarizing film 8B were joined such that incident light was transmitted when a voltage was applied and was not transmitted when no voltage was applied.

A pre-tilt angle of the liquid crystal panel manufactured was in a range of 3° to 9°.

### (Examples 2 to 6)

In each of Examples 2 to 6, a liquid crystal panel was manufactured in the same manner as Example 1 except that an inorganic orientation film formed of SiO₂ was formed with conditions in forming the inorganic orientation film set as shown in Table 1.

### (Examples 7 to 10)

In each of Examples 7 to 10, a liquid crystal panel was manufactured in the same manner as Example 1 except that Al₂O₃ was used as the target 500 and an inorganic orientation film formed of Al₂O₃ was formed with conditions in forming the inorganic orientation film set as shown in Table 1.

### (Example 11)

A liquid crystal panel was manufactured in the same manner as Example 1 except that a target having the shape shown in Fig. 5 was used as the target 500. The first member 510 forming the target 500 had a columnar shape with diameter of 50mm and height of 2mm. The second member 520 had a cylindrical shape with an external diameter of 90mm, an inner diameter of 50mm, and height of 2mm. The third member 530 had a cylindrical shape with an external diameter of 300mm, an inner diameter of 90mm in a portion in contact with the second member 520, an inner diameter of 100mm in a portion in contact with the target holding member S6 (the bonding agent), and height of 3mm.

### (Comparative Example 1)

A liquid panel was manufactured in the same manner as Example 1 except that a solution of polyimide resin (PI) (manufactured by Japan Synthetic Rubber Corporation: AL6256) was prepared, a film with an average thickness of 0.05µm was formed on a transparent conductor film of an opposed substrate for liquid crystal panels by the spin coat method without using the apparatus shown in Fig. 3, and the rubbing treatment was applied to the film such that a pre-tilt angle was 2° to 3° to form an orientation film. In this Comparative Example 1, a substance like dust was generated when the rubbing treatment was applied.

### (Comparative Example 2)

A liquid crystal panel was manufactured in the same manner as Example 1 except that an unseparable member of a disc shape (diameter: 300mm, thickness: 5m) made of SiO₂ was used as the target 500.

### (Comparative Example 3)

A liquid crystal panel was manufactured in the same manner as Example 1 except that an unseparable member of a disc shape (diameter: 250mm, thickness: 5mm) made of SiO₂ was used as the target 500.

### (Comparative Example 4)

A liquid crystal panel was manufactured in the same manner as Example 2 except that sputter particles generated from the target 500 were made incident on an opposed substrate for liquid crystal panels without being tilted.

### (Comparative Example 5)

A liquid crystal panel was manufactured in the same manner as Example 2 except that an inorganic orientation film was formed using a vapor deposition apparatus.

### <Evaluation of efficiency of use of a target>

Formation of an inorganic orientation film was repeatedly carried out for each of the Examples 1 to 11 and Comparative Examples 2 to 4 without replacing a target with the same method as described above. Element analysis was performed for each inorganic orientation film formed. The formation of the inorganic orientation film was stopped at a point when a content of In contained in the inorganic orientation film reached 1ppm or more.

In the Comparative Example 3 in which the target used for the film formation was small, In with a high concentration was detected in the inorganic orientation film formed first.

In each of the Examples 1 to 11 and Comparative Examples 2 and 4, a content of In reached a predetermined concentration or more at a point when substantially the same number of inorganic orientation films were formed. At that time, in each of the Examples 1 to 11, the second member (and the third member) was hardly consumed, and therefore manufacturing of the inorganic orientation film could be repeated by replacing only the first member (without replacing the second member and the third member). In other words, in each of the Examples 1 to 11, only a portion of the target intensely consumed could be replaced and efficiency of use of the target was excellent. In the Examples 1 to 11, even when the second member and the third member continued to be used without being replaced, an amount of detection of In was decreased again by replacing the first member, and a suitable orientation film with less content of impurities could be formed. On the other hand, in the Comparative Eexamples 2 and 4, the entire target had to be replaced in order to continue the manufacturing of the inorganic orientation film.

### <Evaluation of liquid crystal panels>

A light transmittance was continuously measured for each of the liquid crystal panels manufactured (the liquid crystal panels manufactured first) in the Examples 1 to 11 and the Comparative Examples 1 to 5. The measurement of the light transmittance was performed by placing the respective liquid crystal panels under temperature of 50°C and irradiating white light with a light beam density of 151m/mm² in a state in which no voltage is applied.

As the evaluation of the liquid crystal panels, the liquid crystal panels were evaluated in four criteria as described below with time until a light transmittance from start of the irradiation of the white light of the liquid crystal panel manufactured in the Comparative Example 1 fell by 50% as compared to an initial light transmittance (light resistance time) as a reference.
A: The light resistance time was five times or more as compared to that in the Comparative Example 1.
B: The light resistance time was two times or more and less than five times as compared to that in the Comparative Example 1.
C: The light resistance time was one time or more and less than two times as compared to that in the Comparative Example 1.
D: The light resistance time was inferior to that in the Comparative Example 1.

In Table 1, evaluation results of the liquid crystal panels are shown in an organized manner together with conditions for forming an inorganic orientation film, an average thickness of the inorganic orientation film, a pre-tilt angle in each of the liquid crystal panels, and evaluation results of efficiency of use of a target. In Table 1, as evaluation of the efficiency of use of a target, most excellent evaluation is indicated by "A", sufficiently excellent evaluation is indicated by "B", slightly inferior evaluation is indicated by "C", and extremely inferior evaluation is indicated by "D". Further, as an "inner diameter of the second member" and an "inner diameter of the third member" in Table 1, a value of an inner diameter of the second member in a portion in contact with the first member and a value of an inner diameter of the third member in a portion in contact with the second member are described.

As it is evident from Table 1, in the present invention, the target could be efficiently used. In particular, in the Example 11, the efficiency of use of the target was particularly excellent. In other words, in the Example 11, at the time of replacement of the first member, both the second and the third members were hardly consumed. In particular, no change in an external shape of the third member was found. It is conceivable that the third member can be used without change even if the formation of an inorganic orientation film is repeated after that and a replacement time for the second member comes. On the other hand, in each of the Comparative Examples, the efficiency of use of the target was inferior. In particular, in the Comparative Example 3, a high concentration of In was detected in the inorganic orientation film formed first. The target could no longer be used for formation of a suitable inorganic orientation film. In the Comparative Examples 2 and 4, although the target was locally consumed, the entire target inevitably had to be replaced. Thus, the efficiency of use of the target was low.

The liquid crystal panel of the present invention shows excellent light resistance as compared to the liquid crystal panel in the Comparative Example 1. In the liquid crystal panel of the present invention, a sufficient pre-tilt angle was obtained and an orientation state of liquid crystal molecules could be surely regulated. However, in the liquid crystal panels in the Comparative Examples 4 and 5, a sufficient pre-tilt angle was not obtained, and thus it was difficult to regulate an orientation state of liquid crystal molecules.

### <Evaluation of a liquid crystal projector (an electronic equipment)>

A liquid crystal projector (an electronic equipment) having the structure shown in Fig. 12 was assembled using the TFT liquid crystal panels manufactured in each of the Examples 1 to 11 and Comparative Examples 1 to 5. Each liquid crystal projector was continuously driven for 5000 hours.

As evaluation of the liquid crystal projector, a projected image immediately after the driving and a projected image 5000 hours after the driving were observed and clarity of the projected images was evaluated in four criteria as described below.
A: A clear projected image was observed.
B: A substantially clear projected image was observed.
C: A projected image slightly inferior in clarity was observed.
D: An unclear projected image was observed.

The results are shown in Table 2.

As it is evident from Table 2, even when the liquid crystal projector (the electronic device) manufactured using the liquid crystal panel of the present invention was continuously driven for a long time, a clear projected image was obtained.

On the other hand, in the liquid crystal projector manufactured using the liquid crystal panel of the Comparative Example 1, clarity of a projected image evidently fell as a driving time elapsed. It is considered that this is because orientations of liquid crystal molecules were aligned at an initial stage but an orientation film was deteriorated because of driving in a long period of time. As a result, an orientation characteristic of the liquid crystal molecules fell. In the liquid crystal projectors manufactured using the liquid crystal panels in the Comparative Examples 4 and 5, a clear projected image was not obtained from an initial stage of driving. It is considered that this is because an orientation characteristic of the inorganic orientation film was originally low.

When a personal computer, a cellular phone, and a digital still camera including the liquid crystal panel of the present invention were manufactured and the same evaluation was performed, the same results were obtained.

From these results, it is seen that the liquid crystal panel and the electronic device of the present invention are excellent in light resistance and, even when the liquid crystal panel and the electronic device are used for a long period of time, a stable characteristic is maintained.

### <Manufacturing of a liquid crystal panel>

The liquid crystal panel shown in Fig. 8 was manufactured as described below.

### (Example 12)

An opposed substrate for liquid crystal panels was manufactured in the same manner as the Example 1.

An inorganic orientation film was formed on a transparent conductive film of the opposed substrate for liquid crystal panels obtained using the apparatus shown in Fig. 6 as described below.

First, the elliptical target 500 (length in a major axis direction: 500mm, length in a minor axis direction: 350mm, thickness: 5mm) made of SiO₂ shown in Fig. 7 was set in the target holding member S6 formed of copper via In serving as a bonding agent.

Subsequently, the opposed substrate for liquid crystal panels was set on the matrix holder S5 in the vacuum chamber S3 and the vacuum chamber S3 was decompressed to 7.0×10⁻⁵Pa by the exhaust pump S4.

An argon gas was supplied into the ion source S1 from the gas supply source S13 and a voltage was applied to the filament S11 to generate plasma. An ion acceleration voltage of 2000V was applied to the lead-out electrodes S12 to accelerate ions. The target was irradiated with ions in the form of ion beams. An ion beam current of the ion beam irradiated was 250mA.

Sputter particles were led out from the target 500 on which the ion beams were irradiated to the opposed substrate for liquid crystal panels. An inorganic orientation film formed of SiO₂ with an average thickness of 0.05µm was formed on the transparent conductive film. The irradiation angle (the incidence angle) θs of the sputter particles was 80°. Temperature of the opposed substrate for liquid crystal panels in forming the film was 100°C.

When the ion beams were irradiated, the target was moved to reciprocate in a major axis direction thereof. A moving speed of the target was 30mm/second.

The tilt angle θc of columnar crystals forming the inorganic orientation film formed as described above with respect to the opposed substrate for liquid crystal panels was 45° and width of each columnar crystal was 25nm.

In the same manner, an inorganic orientation film was also formed on a surface of a TFT substrate (made of quartz glass) separately prepared.

The opposed substrate for liquid crystal panels on which the inorganic orientation film was formed and the TFT substrate on which the inorganic orientation film was formed were joined via a seal material. This joining was performed to shift orientation directions of the inorganic orientation films by 90° such that liquid crystal molecules forming the liquid crystal layer were twisted to the left.

Subsequently, liquid crystal (manufactured by Merk Ltd.: MJ99247) was injected into a gap portion formed between the inorganic orientation films from filling holes of the gap portion. Then, the filling holes were closed. Thickness of the liquid crystal layer formed was about 3µm.

Thereafter, a TFT liquid crystal panel having the structure shown in Fig. 8 was manufactured by joining the polarizing film 8B and the polarizing film 7B on an outer surface side of the opposed substrate for liquid crystal panels and an outer surface side of the TFT substrate, respectively. As the polarizing films, a polarizing film obtained by extending a film formed of polyvinyl alcohol (PVA) in a uniaxial direction was used. Joining directions of the polarizing film 7B and the polarizing film 8B were determined on the basis of the orientation directions of the inorganic orientation film 3B and the inorganic orientation film 4B, respectively. The polarizing film 7B and the polarizing film 8B were joined such that incident light was transmitted when a voltage was applied and was not transmitted when no voltage was applied.

A pre-tilt angle of the liquid crystal panel manufactured was in a range of 3° to 7°.

### (Examples 13 to 18)

In each of Examples 13 to 18, a liquid crystal panel was manufactured in the same manner as Example 12 except that an inorganic orientation film formed of SiO₂ was formed with conditions in forming the inorganic orientation film set as shown in Table 3.

### (Examples 19 to 21)

In each of Examples 19 to 21, a liquid crystal panel was manufactured in the same manner as Example 12 except that Al₂O₃ was used as the target 500 and an inorganic orientation film formed of Al₂O₃ was formed with conditions in forming the inorganic orientation film set as shown in Table 3.

### (Comparative example 6)

A liquid panel was manufactured in the same manner as Example 12 except that a solution of polyimide resin (PI) (manufactured by Japan Synthetic Rubber Corporation: AL6256) was prepared, a film with an average thickness of 0.05µm was formed on a transparent conductor film of an opposed substrate for liquid crystal panels by the spin coat method without using the apparatus shown in Fig. 6, and the rubbing treatment was applied to the film such that a pre-tilt angle was 2° to 3° to form an orientation film. In this Comparative Example 6, a substance like dust was generated when the rubbing treatment was applied.

### (Comparative Example 7)

A liquid crystal panel was manufactured in the same manner as Example 17 except that a member of a disc shape (diameter: 350mm, thickness: 5mm) made of SiO₂ was used as the target 500 and the target was not moved when ion beams were irradiated.

### (Comparative Example 8)

A liquid crystal panel was manufactured in the same manner as Example 7 except that sputter particles generated from the target 500 were made incident on an opposed substrate for liquid crystal panels without being tilted.

### (Comparative example 9)

A liquid crystal panel was manufactured in the same manner as Example 7 except that an inorganic orientation film was formed using a vapor deposition apparatus.

### <Evaluation of efficiency of use of a target>

Formation of an inorganic orientation film was repeatedly carried out for each of the Examples 12 to 21 and Comparative Examples 7 and 8 without replacing a target with the same method as described above. Element analysis was performed for the inorganic orientation film formed. The formation of the inorganic orientation film was stopped at a point when a content of In contained in the inorganic orientation film reached 0.5ppm or more. Efficiency of use of the target was evaluated in accordance with the four criteria described below.
A: A residue of the target was less than 65% of an initial weight.
B: A residue of the target was equal to or more than 65% and less than 75% of the initial weight.
C: A residue of the target was equal to or more than 75% and less than 85% of the initial weight.
D: A residue of the target was equal to or more than 85% of the initial weight.

### <Evaluation of liquid crystal panels>

A light transmittance was continuously measured for each of the liquid crystal panels manufactured (the liquid crystal panels manufactured first) in the Examples 12 to 21 and Comparative Examples 6 to 9. The measurement of the light transmittance was performed by placing the respective liquid crystal panels under temperature of 50°C and irradiating white light with a light beam density of 151m/mm² in a state in which no voltage is applied.

As the evaluation of the liquid crystal panels, the liquid crystal panels were evaluated in four criteria as described below with time until a light transmittance from start of the irradiation of the white light of the liquid crystal panel manufactured in the Comparative Example 6 fell by 50% as compared to an initial light transmittance thereof (that is, light resistance time) as a reference.
A: The light resistance time was five times or more as compared to that in the Comparative Example 6.
B: The light resistance time was two times or more and less than five times as compared to that in the Comparative Example 6.
C: The light resistance time was one time or more and less than two times as compared to that in the Comparative Example 6.
D: The light resistance time was inferior to that in the Comparative Example 6.

In Table 3, evaluation results of the efficiency of use of the target and evaluation results of the liquid crystal panels are shown in an organized manner together with evaluation results of conditions for forming an inorganic orientation film, an average thickness of the inorganic orientation film, and a pre-tilt angle in each of the liquid crystal panels.

As it is evident from Table 3, in the present invention, the target could be efficiently used. On the other hand, in each of the Comparative Examples 7 and 8, the target was locally consumed and the efficiency of use of the target was low.

The liquid crystal panel of the present invention shows excellent light resistance as compared to the liquid crystal panel of the Comparative Example 6. In the liquid crystal panel of the present invention, a sufficient pre-tilt angle was obtained and an orientation state of liquid crystal molecules could be surely regulated. However, in each of the liquid crystal panels of the Comparative Examples 8 and 9, a sufficient pre-tilt angle was not obtained and it was difficult to regulate an orientation state of liquid crystal molecules.

### <Evaluation of a liquid crystal projector (an electronic equipment)>

A liquid crystal projector (an electronic device) having the structure shown in Fig. 12 was assembled using the TFT liquid crystal panels manufactured in each of the Examples 12 to 21 and Comparative Examples 6 to 9. Each liquid crystal projector was continuously driven for 5000 hours.

As evaluation of the liquid crystal projector, a projected image immediately after the driving and a projected image 5000 hours after the driving were observed and clarity of the projected images was evaluated in the four criteria as described below.
A: A clear projected image was observed.
B: A substantially clear projected image was observed.
C: A projected image slightly inferior in clarity was observed.
D: An unclear projected image was observed.

The results are shown in Table 4.

As it is evident from Table 4, even when the liquid crystal projector (the electronic device) manufactured using the liquid crystal panel of the present invention was continuously driven for a long time, a clear projected image was obtained.

On the other hand, in the liquid crystal projector manufactured using the liquid crystal panel of the Comparative Example 6, clarity of a projected image evidently fell as a driving time elapsed. It is considered that this is because orientations of liquid crystal molecules were aligned at an initial stage but an orientation film was deteriorated because of driving in a long period of time. As a result, an orientation characteristic of the liquid crystal molecules fell. In the liquid crystal projectors manufactured using the liquid crystal panels in the Comparative Examples 8 and 9, a clear projected image was not obtained from an initial stage of driving. It is considered that this is because an orientation characteristic of the inorganic orientation film was originally low.

When a personal computer, a cellular phone, and a digital still camera including the liquid crystal panel of the present invention were manufactured and the same evaluation was performed, the same results were obtained.

From these results, it is seen that the liquid crystal panel and the electronic equipment of the present invention are excellent in light resistance and, even when the liquid crystal panel and the electronic equipment are used for a long period of time, a stable characteristic is obtained.

Finally, it is to be noted that although certain preferred embodiments of the present invention have been shown and described in detail in the above, it should be understood that various changes and modifications may be made therein without departing from the scope of the appended claims.

## Claims

1. A method of forming an inorganic orientation film, in which a target is irradiated with ion beams supplied from an ion beam source to lead out sputter particles from the target, and then the sputter particles are made incident on a matrix to form the inorganic orientation film,
wherein the film formation is carried out without replacing the whole of the target while carrying out a repair processing for supplementing or recovering a defect of the target.

2. The method of forming an inorganic orientation film as claimed in claim 1, wherein the target is formed from a plurality of separable members so that only a part of the separable members can be selected and replaced, and the repair processing is carried out by replacing a member within the plural separable members on which the defect is produced.

3. The method of forming an inorganic orientation film as claimed in claim 2, wherein the target includes a first member of a column shape and a second member of a cylindrical shape which is arranged so as to surround the outer periphery of the first member.

4. The method of forming an inorganic orientation film as claimed in claim 3, wherein the first member is a column shaped member having a diameter of 25 to 250mm.

5. The method of forming an inorganic orientation film as claimed in claim 2, wherein the diameter of the target as a whole is in the range of 100 to 350mm.

6. The method of forming an inorganic orientation film as claimed in claim 1, wherein the repair processing is carried out by changing the irradiating position of the ion beams on the target with time.

7. The method of forming an inorganic orientation film as claimed in claim 6, wherein when the target is irradiated with the ion beams, the target is moved relative to the ion beam source and the matrix.

8. The method of forming an inorganic orientation film as claimed in claim 6, wherein the moving speed of the target relative to the ion source and the matrix is in the range of 0.01 to 40mm/second.

9. The method of forming an inorganic orientation film as claimed in claim 6, wherein the relative movement of the target is a reciprocal movement in one-dimensional direction.

10. The method of forming an inorganic orientation film as claimed in claim 6, wherein the length of the target in the plane from which the ion beams are made incident and in the direction of the movement thereof is longer than the length of the target in its vertical direction.

11. The method of forming an inorganic orientation film as claimed in claim 1, wherein an acceleration voltage of the ion beams at the irradiating the ion beams is 1200V or more.

12. The method of forming an inorganic orientation film as claimed in claim 1, wherein an ion beam current of the irradiating ion beams is in the range of 50 to 500mA.

13. The method of forming an inorganic orientation film as claimed in claim 1, wherein the sputter particles are made incident on the matrix from the direction inclined at a predetermined angle θs with respect to a vertical direction of a surface of the matrix on which the inorganic orientation film is to be formed, thereby forming the inorganic orientation film in which columnar crystals mainly made from the inorganic material are orientated in an inclined manner with respect to the surface of the matrix on which the inorganic orientation film is to be formed.

14. The method of forming an inorganic orientation film as claimed in claim 13, wherein the predetermined angle θs is 40° or larger.

15. The method of forming an inorganic orientation film as claimed in claim 1, wherein the shaped of the columnar crystals near the vertexes thereof are controlled by controlling energy and/or the number of the sputter particles that reach the matrix.

16. The method of forming an inorganic orientation film as claimed in claim 1, wherein the columnar crystals are oriented with being inclined at a predetermined angle θc with respect to the matrix.

17. The method of forming an inorganic orientation film as claimed in claim 1, wherein the inorganic orientation film is formed of an inorganic material including silicon oxide.

18. An inorganic orientation film formed by the inorganic orientation film forming method as defined in claim 1.

19. The inorganic orientation film as claimed in claim 18, wherein an average thickness of the inorganic orientation film is in the range of 0.02 to 0.3µm.

20. A substrate for electronic devices, comprising a substrate on which electrodes and inorganic orientation films defined by claim 18 are provided.

21. A liquid crystal panel comprising an inorganic orientation films defined in claim 18 and a liquid crystal layer.

22. Electronic equipment provided with the liquid crystal panel defined by claim 21.
